(19) Europäisches Patentamt / European Patent Office / Office européen des brevets

(11) **EP 4 047 032 A1**

(12) **EUROPEAN PATENT APPLICATION**
published in accordance with Art. 153(4) EPC

(43) Date of publication:
**24.08.2022 Bulletin 2022/34**

(21) Application number: **20875946.4**

(22) Date of filing: **10.09.2020**

(51) International Patent Classification (IPC):
***C08G 61/12*** *(2006.01)* ***C08K 5/00*** *(2006.01)*
***C08K 5/18*** *(2006.01)* ***C08L 65/00*** *(2006.01)*
***H01L 51/50*** *(2006.01)*

(52) Cooperative Patent Classification (CPC):
**C08G 61/00; C08G 61/12; C08K 5/00; C08K 5/18; C08L 65/00; H01L 51/50**

(86) International application number:
**PCT/JP2020/034231**

(87) International publication number:
**WO 2021/075183 (22.04.2021 Gazette 2021/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.10.2019 JP 2019188927**

(71) Applicant: **SUMITOMO CHEMICAL COMPANY, LIMITED**
**Tokyo 103-6020 (JP)**

(72) Inventors:
- **ISHINO, Yuta**
**Osaka-shi, Osaka 554-8558 (JP)**
- **SUGIYAMA, Mayuko**
**Osaka-shi, Osaka 554-8558 (JP)**

(74) Representative: **J A Kemp LLP**
**80 Turnmill Street**
**London EC1M 5QU (GB)**

# (54) COMPOSITION AND LIGHT-EMITTING ELEMENT CONTAINING SAME

(57) The present invention has an object of providing a composition which is useful for production of an organic layer excellent in curability used in a light emitting device.

A composition, containing cyclic low molecular compounds having a constitutional unit represented by the formula (X), and a polymer compound having the same constitutional unit represented by the formula (X) as in the above-described cyclic low molecular compound, wherein the total value of area percentages determined by liquid chromatography of the above-described cyclic low molecular compounds is 0.1 or more and 1.5 or less when the total value of area percentages determined by liquid chromatography of the above-described cyclic low molecular compounds and the above-described polymer compound is taken as 100, a film for light emitting device, and a light emitting device.

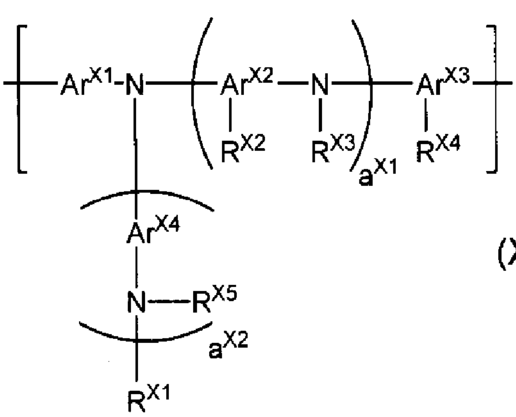

(X)

[wherein, $a^{X1}$ and $a^{X2}$ each independently represent an integer of 0 or more. $Ar^{X1}$ and $Ar^{X3}$ each independently represent an arylene group, a divalent hetero ring group or the like. $Ar^{X2}$ and $Ar^{X4}$ each independently represent an arylene group, a divalent hetero ring group and the like. $R^{x1}$ to $R^{X5}$ each independently represent a hydrogen atom, an alkyl group, a cycloalkyl group, an aryl group and the like.].

EP 4 047 032 A1

## Description

### Field of the Invention

The present invention relates to a composition and a light emitting device containing the same.

### Background Art

Light emitting devices such as an organic electroluminescent device (hereinafter, referred to also as organic EL device) and the like can be suitably used for applications of display and illumination. The organic layer constituting the light emitting device can be formed by a wet film formation method using a composition containing a polymer compound. This polymer compound is produced by various production methods, and contains a cyclic low molecular compound in some cases depending on its production method. When a film is formed using a polymer compound containing this cyclic low molecular compound, the film formation is reversely influenced, hence, it is desired that the polymer compound contains no cyclic low molecular compound. For example, Patent Document 1 reports a conjugated polymer having prescribed weight-average molecular weight and degree of dispersion in which low molecular weight components such as a cyclic oligomer and the like are reduced, and Patent Document 2 reports a high molecular weight compound in which low molecular weight components containing a cyclic compound are reduced.

### Prior Art Document

### Patent Document

Patent Document 1: Japanese Unexamined Patent Application Publication (JP-A) No. 2009-287000
Patent Document 2: JP-A No. 2005-209626

### Summary of the Invention

### Problem to be Solved by the Invention

An organic layer of a light emitting device is composed of a multi-layered film, and can be formed using a wet film formation method in which solutions containing a polymer compound are sequentially applied and dried. In this case, if an organic substance is eluted and mixed from the lower film when applying a solution on the previously formed film, the function of each film is lost to exert a reverse influence on the property of the light emitting device. For this reason, it is desired that the film after application and drying has high durability (i.e., curability) against a solvent. However, in the light emitting devices described in Patent Documents 1 and 2 described above, the curability of the film was not necessarily sufficient. Then, the main object of the present invention is to provide a composition which is useful for production of an organic layer (film) excellent in curability used in a light emitting device.

### Means for Solving the Problem

The present invention provides the following [1] to [7].

[1] A composition comprising cyclic low molecular compounds having a constitutional unit represented by the formula (X), and a polymer compound having the same constitutional unit represented by the formula (X) as in the above-described cyclic low molecular compound, wherein the total value of area percentages determined by liquid chromatography of the above-described cyclic low molecular compounds is 0.1 or more and 1.5 or less, when the total value of area percentages determined by liquid chromatography of the above-described cyclic low molecular compounds and the above-described polymer compound is taken as 100:

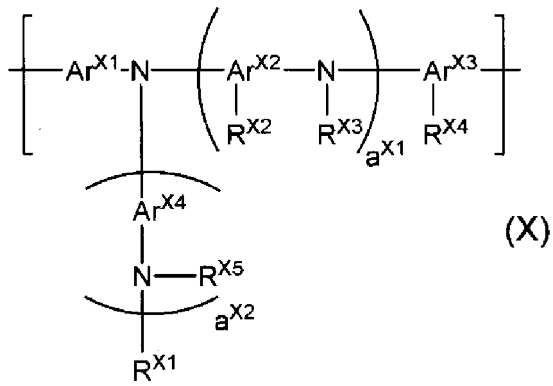

(X)

[wherein,

$a^{X1}$ and $a^{X2}$ each independently represent an integer of 0 or more.

$Ar^{X1}$ and $Ar^{X3}$ each independently represent an arylene group or a divalent hetero ring group, and these groups optionally have a substituent.

$Ar^{X2}$ and $Ar^{X4}$ each independently represent an arylene group, a divalent hetero ring group, or a divalent group in which an arylene group and a divalent hetero ring group are bonded directly, and these groups optionally have a substituent. When a plurality of $Ar^{X2}$ and $Ar^{X4}$ are present, they may be the same or different at each occurrence.

$R^{X1}$ to $R^{X5}$ each independently represent a hydrogen atom, an alkyl group, a cycloalkyl group, an aryl group, a monovalent hetero ring group, or a group containing a cross-linkable group, and these groups optionally have a substituent. When a plurality of $R^{X2}$, $R^{X3}$ and $R^{X5}$ are present, they may be the same or different at each occurrence.].

[2] The composition according to [1], wherein the molecular weight of the above-described cyclic low molecular compound is 1000 to 10000.

[3] The composition according to[1] or [2], comprising a cyclic low molecular compound having a constitutional unit represented by the above-described formula (X) and a constitutional unit represented by the formula (Y), and a polymer compound having the same constitutional unit represented by the formula (X) and the same constitutional unit represented by the formula (Y) as in the above-described cyclic low molecular compound:

$$-\!\!\left[\!-Ar^{Y1}-\!\right]\!\!- \quad (Y)$$

[wherein, $Ar^{Y1}$ represents an arylene group, a divalent hetero ring group, or a divalent group in which an arylene group and a divalent hetero ring group are bonded directly, and these groups optionally have a substituent.].

[4] The composition according to any one of [1] to [3], wherein the above-described cyclic low molecular compound is a cyclic compound represented by the formula (Z) :

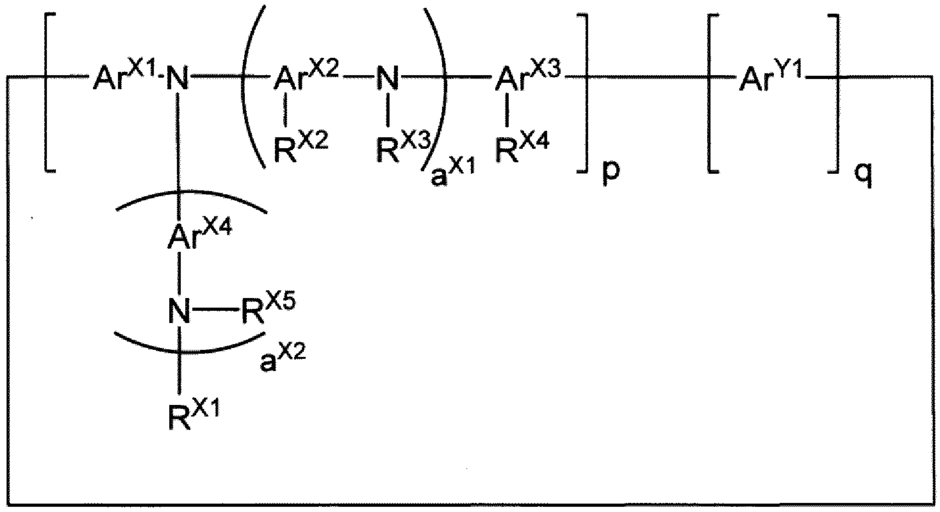

(Z)

[wherein, p represents an integer of 1 to 8, q represents an integer of 0 to 8, and $3 \leq p+q \leq 16$. Other marks are as defined above. The order of bonding of the constitutional unit represented by the formula (X) and the constitutional unit represented by the formula (Y) is not restricted. When a plurality of constitutional units represented by the formula (X) are present, the constitutional units may be the same or different. When a plurality of constitutional units represented by the formula (Y) are present, the constitutional units may be the same or different.].

[5] The composition according to any one of [1] to [4], further comprising at least one selected from the group consisting of a hole transporting material, a hole injection material, an electron transporting material, an electron injection material, a light emitting material and an antioxidant.

[6] A film for light emitting device, comprising the composition as described in any one of [1] to [5] and/or a cured product thereof.

[7] A light emitting device having an anode, a cathode and an organic layer, wherein the above-described organic layer is disposed between the above-described anode and the above-described cathode, and the above-described organic layer is the film for light emitting device as described in [6].

Effect of the Invention

According to the present invention, a composition which is useful for formation of an organic layer (film) excellent in curability in a light emitting device can be provided. Further, according to the present invention, a light emitting device containing an organic layer (film) containing the composition or a cured product thereof can be provided.

Brief Explanation of Drawings

FIG. 1 is a chart of liquid chromatographic analysis of a mixture A obtained in Synthesis Example 1.

FIG. 2 is a chart of liquid chromatographic analysis of a polymer compound (P2) obtained in Synthesis Example 2.

FIG. 3 shows the result of MALDI-TOFMS analysis of components (including cyclic low molecular compound) around 6.0 minutes in the chart of liquid chromatographic analysis of a mixture A.

FIG. 4 is a graph showing a relationship between the film remaining ratio and the content (area percentage) of a cyclic low molecular compound in compositions used in Examples 1 to 3 and Comparative Examples 1 to 3.

Modes for Carrying Out the Invention

Suitable embodiments of the present invention will be illustrated in detail below

1. Explanation of common terms

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a deuterated hydrogen atom or a light hydrogen atom.

In the formula representing a metal complex, the solid line representing a bond with a metal denotes an ionic bond, a covalent bond or a coordination bond.

"The polymer compound" means a polymer having molecular weight distribution and having a weight-average molecular weight determined by gel permeation chromatography (GPC) (polystyrene-equivalent) of $1\times10^3$ to $1\times10^8$.

The polymer compound may be any of a block copolymer, a random copolymer, an alternative copolymer or a graft copolymer, or may be in other form.

It is preferable that the polymer compound has a chain-like structure, and both end groups have a stable group. This is because if the polymerization active group remains intact on the end group, the light emitting property or the luminance life may possibly be deteriorated when the polymer compound is used for manufacturing a light emitting device. The end group of the polymer compound is preferably a group conjugatively bonded to the main chain, and includes, for example, aryl groups (phenyl group and the like) or monovalent hetero ring groups bonding to the main chain of the polymer compound via a carbon-carbon bond.

"The low molecular compound" means a compound not having molecular weight distribution and having a molecular weight of $1\times10^4$ or less.

"The constitutional unit" means a unit occurring once or more times (further, twice or more times) in a polymer compound or a low molecular compound. The constitutional unit occurring twice or more times in a polymer compound or a low molecular compound is in general called "repeating unit".

"The alkyl group" may be any of linear or branched. The number of carbon atoms of the linear alkyl group is usually 1 to 50, preferably 3 to 30, and more preferably 4 to 20. The number of carbon atoms of the branched alkyl group is usually 3 to 50, preferably 3 to 30, and more preferably 4 to 20.

"The alkyl group" optionally has a substituent, and the alkyl group optionally having a substituent includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom and the like (for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group) .

The number of carbon atoms of "the cycloalkyl group" is usually 3 to 50, preferably 3 to 30, and more preferably 4 to 20.

"The cycloalkyl group" optionally has a substituent, and the cycloalkyl group optionally having a substituent includes, for example, a cyclohexyl group, a cyclohexylmethyl group, and a cyclohexylethyl group.

"The aryl group" means an atomic group remaining after removing from an aromatic hydrocarbon one hydrogen atom bonding directly to a carbon atom constituting the ring. The number of carbon atoms of the aryl group is usually 6 to 60, preferably 6 to 20, and more preferably 6 to 10.

"The aryl group" optionally has a substituent, and the aryl group optionally having a substituent includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom, and the like.

"The alkoxy group" may be any of linear or branched. The number of carbon atoms of the linear alkoxy group is usually 1 to 40, and preferably 4 to 10. The number of carbon atoms of the branched alkoxy group is usually 3 to 40, and preferably 4 to 10.

"The alkoxy group" optionally has a substituent, and the alkoxy group optionally having a substituent includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom, and the like.

The number of carbon atoms of "the cycloalkoxy group" is usually 3 to 40, and preferably 4 to 10.

"The cycloalkoxy group" optionally has a substituent, and the cycloalkoxy group optionally having a substituent includes, for example, a cyclohexyloxy group.

The number of carbon atoms of "the aryloxy group" is usually 6 to 60, and preferably 6 to 48. "The aryloxy group" optionally has a substituent, and the aryloxy group optionally having a substituent includes, for example, a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom and the like.

"The p-valent hetero ring group" (p represents an integer of 1 or more, particularly 1 or 2) means an atomic group remaining after removing from a heterocyclic compound p hydrogen atoms among hydrogen atoms bonding directly to carbon atoms or hetero atoms constituting the ring. Of the p-valent hetero ring groups, "a p-valent aromatic hetero ring group" which is an atomic group remaining after removing from an aromatic heterocyclic compound p hydrogen atoms among hydrogen atoms bonding directly to carbon atoms or hetero atoms constituting the ring is preferred.

"The aromatic heterocyclic compound" means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to a hetero ring even if the hetero ring itself shows no aromaticity such as phenoxazine, phenothiazine, dibenzoborole, dibenzosilole, benzopyran and the like.

The number of carbon atoms of "the monovalent hetero ring group" is usually 2 to 60, and preferably 4 to 20.

"The monovalent hetero ring group" optionally has a substituent, and the monovalent hetero ring group optionally having a substituent includes, for example, a thienyl group, a pyrrolyl group, a furyl group, a pyridyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group and the like.

"The halogen atom" denotes a fluorine atom, a chlorine atom, a bromine atom or an iodine atom.

"The amino group" optionally has a substituent, and substituted amino groups are preferred. As the substituent which an amino group has, an alkyl group, a cycloalkyl group, an aryl group or a monovalent hetero ring group is preferred.

The substituted amino group includes, for example, a dialkylamino group, a dicycloalkylamino group and a diarylamino group. Specific examples thereof include, for example, a dimethylamino group, a diethylamino group, a diphenylamino group, a bis(4-methylphenyl)amino group, a bis(4-tert-butylphenyl)amino group, and a bis(3,5-di-tert-butylphenyl)amino group.

"The alkenyl group" may be any of linear or branched. The number of carbon atoms of the linear alkenyl group is usually 2 to 30, and preferably 3 to 20. The number of carbon atoms of the branched alkenyl group is usually 3 to 30, and preferably 4 to 20.

The number of carbon atoms of "the cycloalkenyl group" is usually 3 to 30, and preferably 4 to 20.

"The alkenyl group" and "the cycloalkenyl group" optionally have a substituent, and the alkenyl group and the cycloalkenyl group optionally having a substituent include, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"The alkynyl group" may be any of linear or branched. The number of carbon atoms of the alkynyl group is usually 2 to 20, and preferably 3 to 20. The number of carbon atoms of the branched alkynyl group is usually 4 to 30, and preferably 4 to 20.

The number of carbon atoms of "the cycloalkynyl group" is usually 4 to 30, and preferably 4 to 20.

"The alkynyl group" and "the cycloalkynyl group" optionally have a substituent, and the alkynyl group and the cycloalkynyl group optionally having a substituent include, for example, an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"The arylene group" means an atomic group remaining after removing from an aromatic hydrocarbon two hydrogen atoms bonding directly to carbon atoms constituting the ring. The number of carbon atoms of the arylene group is usually 6 to 60, preferably 6 to 30, and more preferably 6 to 18.

"The arylene group" optionally has a substituent, and the arylene group optionally having a substituent includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, and these groups having a substituent, and preferable are groups represented by the formula (A-1) to formula (A-20). The arylene group includes groups in which multiple of these groups are bonded.

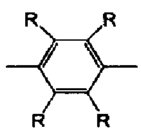
(A-1)

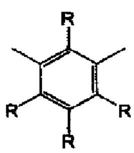
(A-2)

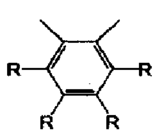
(A-3)

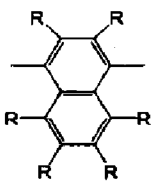
(A-4)

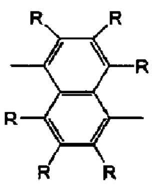
(A-5)

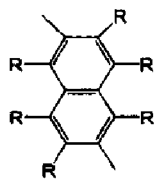
(A-6)

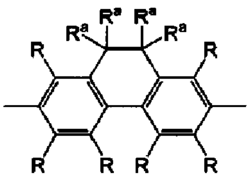
(A-7)
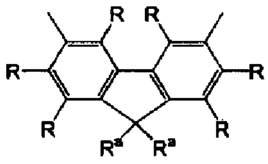
(A-8)
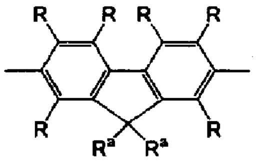
(A-9)
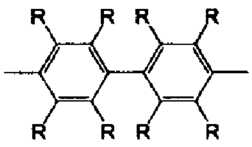
(A-10)

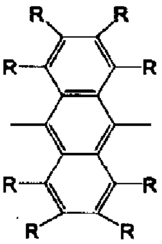
(A-11)
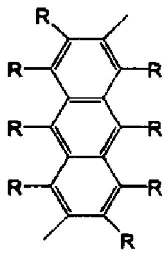
(A-12)
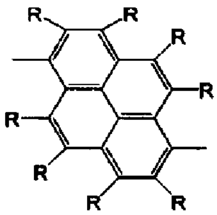
(A-13)
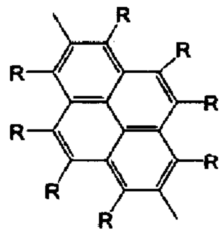
(A-14)
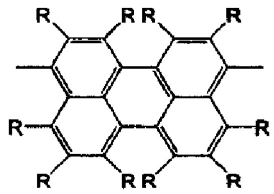
(A-15)

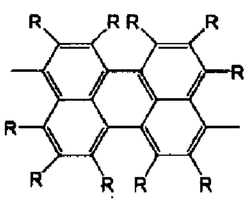
(A-16)
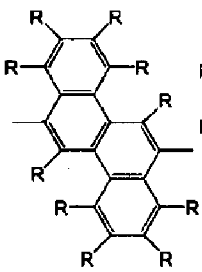
(A-17)
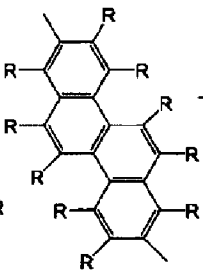
(A-18)
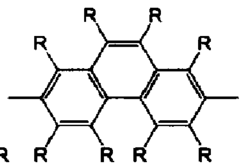
(A-19)
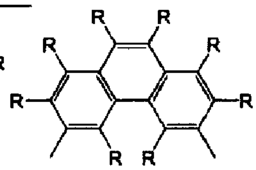
(A-20)

[wherein, R and $R^a$ each independently represent a hydrogen atom, an alkyl group, a cycloalkyl group, an aryl group or a monovalent hetero ring group. A plurality of R and $R^a$ each may be the same or different, and groups $R^a$ may be combined together to form a ring together with atoms to which they are attached.].

The number of carbon atoms of "the divalent hetero ring group" is usually 2 to 60, preferably 3 to 20, and more preferably 4 to 15.

"The divalent hetero ring group" optionally has a substituent, and the divalent hetero ring group optionally having a substituent includes, for example, divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or triazole two hydrogen atoms among hydrogen atoms bonding directly to carbon atoms or hetero atoms constituting the ring, and preferable are groups represented by the formula (AA-1) to formula (AA-34). The divalent hetero ring group includes groups in which multiple of these groups are bonded.

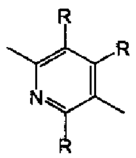
(AA-1)
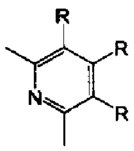
(AA-2)
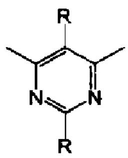
(AA-3)
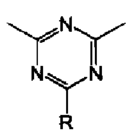
(AA-4)
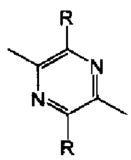
(AA-5)
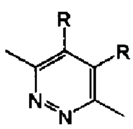
(AA-6)
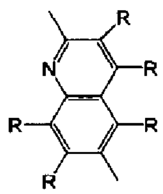
(AA-7)

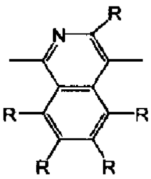
(AA-8)

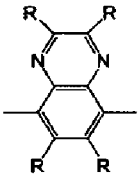
(AA-9)

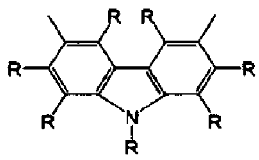
(AA-10)

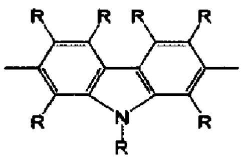
(AA-11)

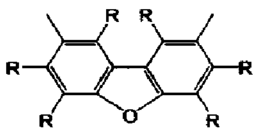
(AA-12)

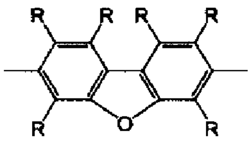
(AA-13)

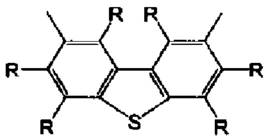
(AA-14)

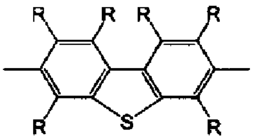
(AA-15)

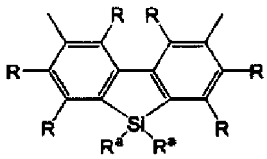
(AA-16)

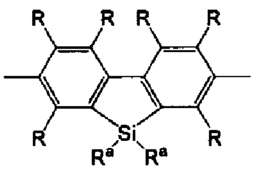
(AA-17)

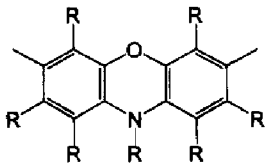
(AA-18)

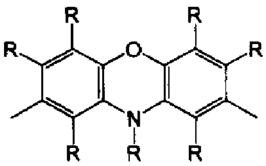
(AA-19)

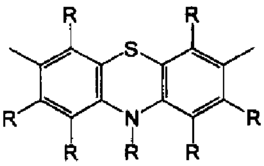
(AA-20)

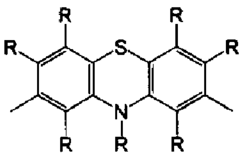
(AA-21)

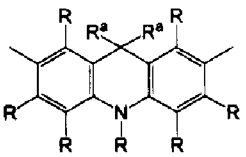
(AA-22)

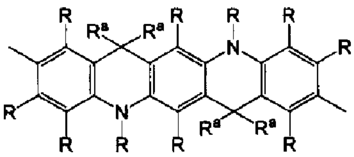
(AA-23)

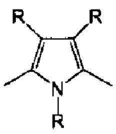
(AA-24)

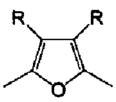
(AA-25)

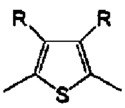
(AA-26)

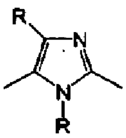
(AA-27)

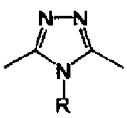
(AA-28)

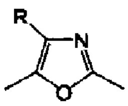
(AA-29)

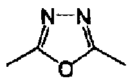
(AA-30)

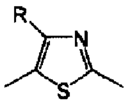
(AA-31)

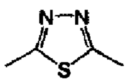
(AA-32)

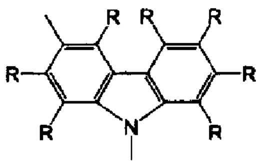
(AA-33)

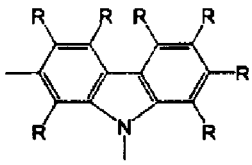
(AA-34)

[wherein, R and $R^a$ represent the same meaning as described above.].

"The cross-linkable group" is a group capable of generating a new bond by being subjected to heating treatment, ultraviolet ray irradiation treatment, near ultraviolet ray irradiation treatment, visible light irradiation treatment, infrared ray irradiation treatment, radical reaction, and the like. Cross-linkable groups represented by the formula (XL-1) to formula (XL-19) in Group A of cross-linkable group are preferable, and cross-linkable groups represented by the formula (XL-1) or formula (XL-17) are more preferable.

(Group A of cross-linkable group)

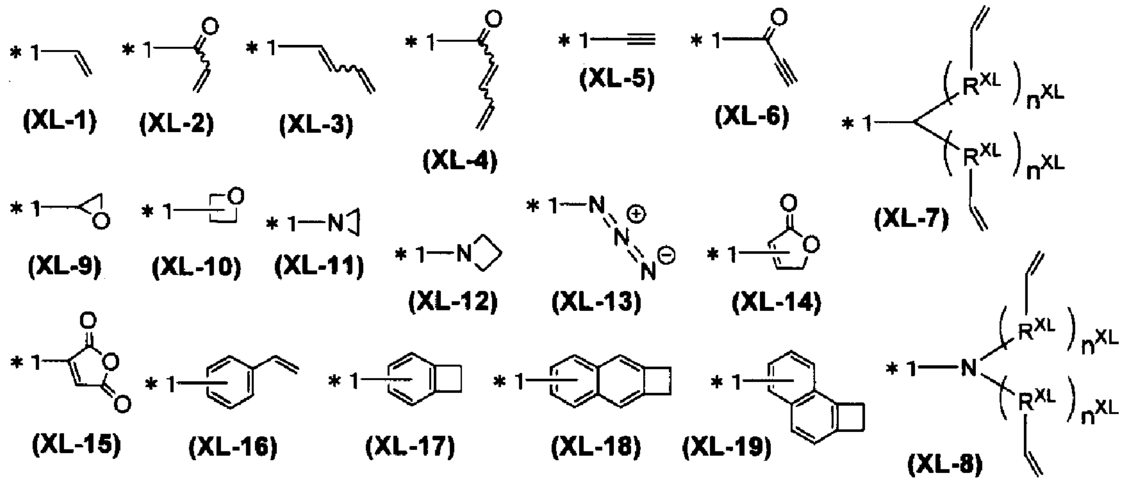

(XL-1) (XL-2) (XL-3) (XL-4) (XL-5) (XL-6) (XL-7) (XL-8) (XL-9) (XL-10) (XL-11) (XL-12) (XL-13) (XL-14) (XL-15) (XL-16) (XL-17) (XL-18) (XL-19)

[wherein,

$R^{XL}$ represents a methylene group, an oxygen atom, a sulfur atom or -CO-,
$n^{XL}$ represents an integer of 0 to 5. When a plurality of $R^{XL}$ are present, they may be the same or different. A plurality of $n^{XL}$ may be the same or different.
*1 represents a binding position.

These cross-linkable groups optionally have a substituent, and when a plurality of the substituents are present, they may be combined together to form a ring together with carbon atoms to which they are attached.].

In the formula (XL-2) to formula (XL-4), the wavy line represents an isomer (preferably Z form or E form). When a plurality of the wavy lines are present, they may be the same or different.

"The group containing a cross-linkable group" includes, for example, groups represented by the formula (1) .

$$-L-Y \qquad (1)$$

[wherein, L represents a single bond, or $-(CH_2)-$, -O-, -S-, -(CO)-, $-(C_6H_4)-$, or a divalent group obtained by bonding two or more groups selected from these. However, -O-groups, -S- groups, and -O- and -S- are not directly combined together. Y represents a cross-linkable group. When a plurality of Y are present, they may be the same or different.].

L includes, for example, $-(CH_2)_m-$ (m represents an integer of 0 to 20), $-(CH_2)_p-(C_6H_4)-(CH_2)_q-$ (p represents an integer of 0 to 10, q represents an integer of 0 to 10), $-(CH_2)_r-O-(CH_2)_s-$ (r represents an integer of 0 to 10, s represents an integer of 0 to 10), $-(CH_2)_t-(C_6H_4)-O-(CH_2)_u-$(t represents an integer of 0 to 10, u represents an integer of 0 to 10), and the like.

"The substituent" represents, for example, a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may also be a group containing a cross-linkable group.

## 2. Composition

The composition of the present invention contains prescribed amounts of cyclic low molecular compounds having a constitutional unit represented by the formula (X), and a polymer compound having the same constitutional unit represented by the formula (X) as in the above-described cyclic low molecular compound. The total value of area percentages determined by liquid chromatography of the above-described cyclic low molecular compounds is 0.1 or more and 1.5 or less (for example, may be 0.2 or more and 1.5 or less, may also be 0.3 or more and 1.4 or less) when the total value of area percentages determined by liquid chromatography of the above-described cyclic low molecular compounds and the above-described polymer compound is taken as 100.

The above-described area percentage of the cyclic low molecular compounds contained in the composition of the present invention is preferably 0.1 or more and 1.3 or less, more preferably 0.2 or more and 1.2 or less, further preferably 0.2 or more and 1.1 or less, and particularly preferably 0.4 or more and 1.1 or less. When the amount of the cyclic low molecular compounds contained in a light emitting device is within this range, the curability of an organic layer

of the light emitting device using the composition is improved.

(1) Polymer compound

The polymer compound contained the composition of the present invention has the same constitutional unit represented by the formula (X) as in the above-described cyclic low molecular compound.

In the above-described polymer compound, the upper limit of the content rate (mol fraction) of the constitutional unit represented by the formula (X) is, for example, 80% by mol, preferably 70% by mol, and further preferably 60% by mol, and its lower limit is, for example, 1% by mol, preferably 10% by mol, and further preferably 30% by mol, with respect to the total molar amount of constitutional units contained in the polymer compound. The constitutional unit represented by the formula (X) may be contained only singly or in combination of two or more in the polymer compound.

It is preferable that the above-described polymer compound further contains a constitutional unit represented by the formula (Y), since the light emitting device of the present embodiment is more excellent in luminance life. The upper limit of the content rate (mol fraction) of the constitutional unit represented by the formula (Y) is, for example, 90% by mol, preferably 80% by mol, and more preferably 70% by mol, and its lower limit is, for example, 0.5% by mol, preferably 10% by mol, and further preferably 30% by mol, with respect to the total molar amount of constitutional units contained in the polymer compound. The constitutional unit represented by the formula (Y) may be contained only singly or in combination of two or more in the polymer compound.

The above-described polymer compound may further contain other constitutional units. The content rate (mol fraction) of the other constitutional unit is, for example, 20% by mol or less, and further preferably 10% by mol or less, with respect to the total molar amount of constitutional units contained in the polymer compound. The other constitutional unit may be contained only singly or in combination of two or more in the polymer compound.

The preferable embodiment of the above-described polymer compound is, for example, a polymer compound containing a constitutional unit represented by the formula (X) and a constitutional unit represented by the formula (Y), and includes those in which the amount of a constitutional unit represented by the formula (X) is 1 to 80% by mol (preferably, 30 to 60% by mol), the amount of a constitutional unit represented by the formula (Y) is 1 to 90% by mol (preferably, 30 to 70% by mol), and the sum of the mol fractions of a constitutional unit represented by the formula (X) and a constitutional unit represented by the formula (Y) is 70 to 100% by mol, with respect to the total molar amount of constitutional units contained in the polymer compound.

It is preferable that the above-described polymer compound has at least one cross-linkable group selected from Group A of cross-linkable group described above, since the curability of an organic layer (film) of a light emitting device can be improved.

The constitutional unit represented by the formula (X) and the constitutional unit represented by the formula (Y) will be described later.

The above-described polymer compound may be any of a block copolymer, a random copolymer, an alternative copolymer, or a graft copolymer, and may also be in other form. Copolymers obtained by copolymerizing several kinds of raw material monomers are preferable.

The weight-average molecular weight determined by GPC (polystyrene-equivalent) of the above-described polymer compound is preferably $5\times10^3$ to $1\times10^7$, more preferably $1\times10^4$ to $1\times10^6$, and further preferably $1.5\times10^4$ to $5\times10^5$.

<Constitutional unit represented by the formula (X)>

$a^{X1}$ is preferably 0, 1 or 2, more preferably 0 or 1, and further preferably 1, since the light emitting device of the present embodiment is more excellent in luminance life.

$a^{X2}$ is preferably 0, 1 or 2, and more preferably 0, since the light emitting device of the present embodiment is more excellent in luminance life.

$R^{X1}$ to $R^{X5}$ represent preferably an alkyl group, a cycloalkyl group, an aryl group, a monovalent hetero ring group, or a cross-linkable group selected from Group A of cross-linkable group, more preferably an aryl group or a cross-linkable group selected from Group A of cross-linkable group, and these groups optionally have a substituent.

The examples and the preferable ranges of "the arylene group" and "the divalent hetero ring group" represented by $Ar^{X1}$ to $Ar^{X4}$ are the same as the examples and the preferable ranges of "the arylene group" and "the divalent hetero ring group" represented by $Ar^{Y1}$ in the formula (Y) described later, respectively.

The examples and the preferable ranges of "the arylene group" and "the divalent hetero ring group" in "the divalent group in which an arylene group and a divalent hetero ring group are bonded directly" represented by $Ar^{X2}$ and $Ar^{X4}$ are the same as the examples and the preferable ranges of "the arylene group" and "the divalent hetero ring group" represented by $Ar^{Y1}$ in the formula (Y) described later, respectively.

"The divalent group in which an arylene group and a divalent hetero ring group are bonded directly" represented

by $Ar^{X2}$ and $Ar^{X4}$ includes those that are the same as "the divalent group in which an arylene group and a divalent hetero ring group are bonded directly" represented by $Ar^{Y1}$ in the formula (Y) described later.

$Ar^{X1}$ to $Ar^{X4}$ are preferably arylene groups optionally having a substituent.

The examples and the preferable range of the "substituent" which the group represented by $Ar^{X1}$ to $Ar^{X4}$ optionally has are the same as the examples and the preferable range of the "substituent" which the group represented by $Ar^{Y1}$ in the formula (Y) described later optionally has.

The constitutional unit represented by the formula (X) containing no cross-linkable group includes, for example, constitutional units represented by the formula (X1-1) to formula (X1-15).

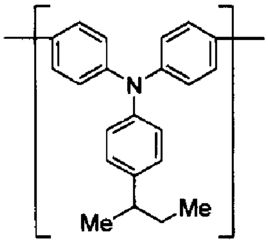

(X1-1)

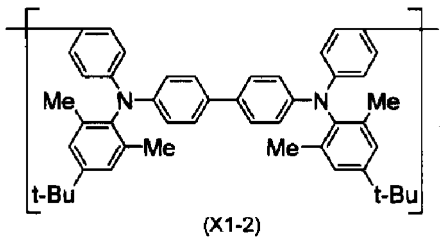

(X1-2)

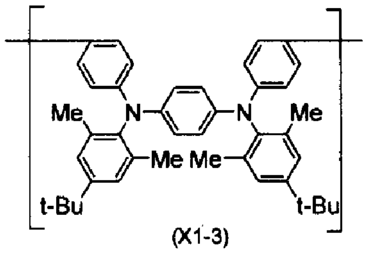

(X1-3)

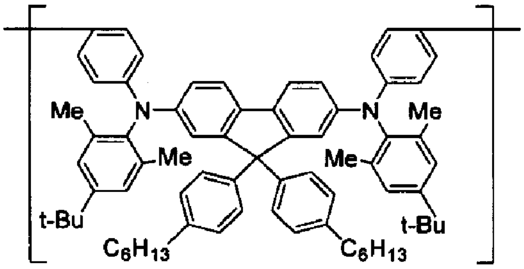

(X1-4)

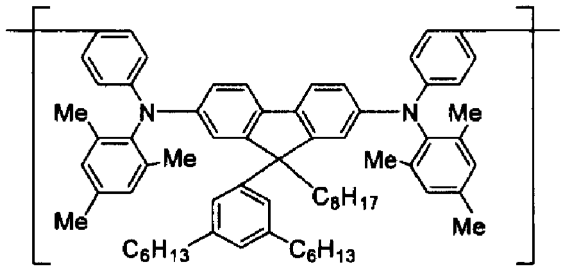

(X1-5)

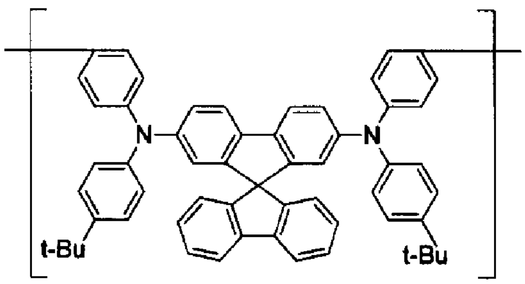

(X1-6)

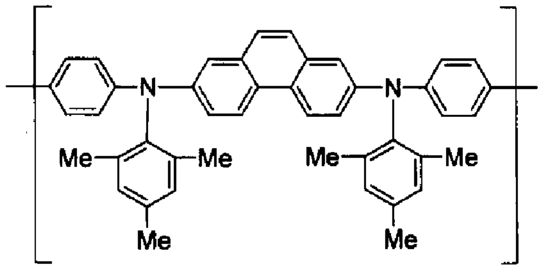

(X1-7)

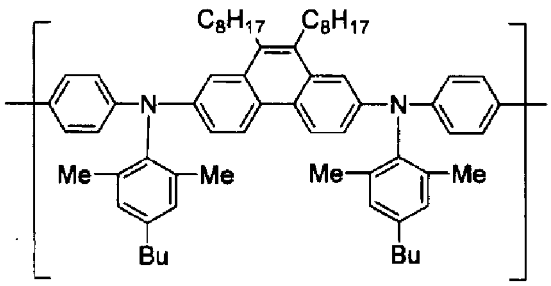

(X1-8)

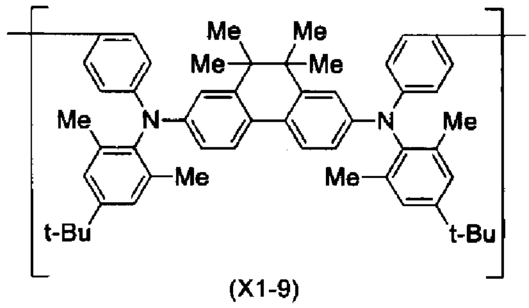

(X1-9)

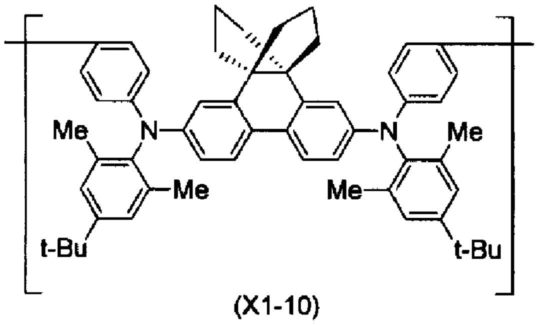

(X1-10)

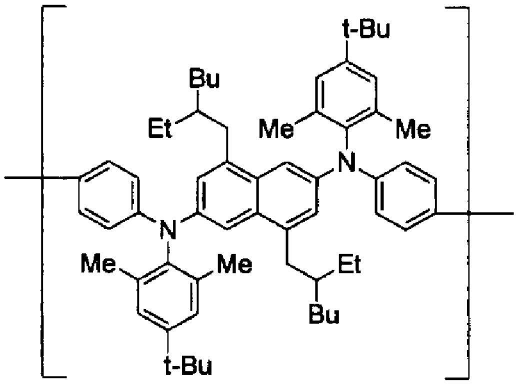

(X1-11)

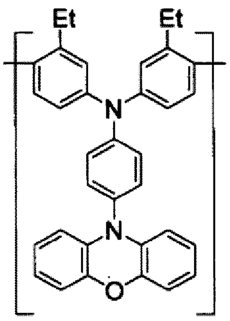

(X1-12)

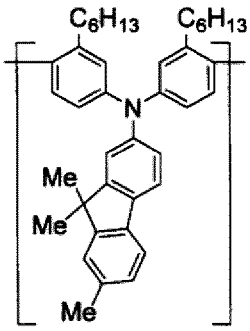

(X1-13)

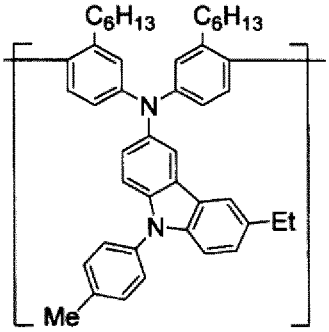

(X1-14)

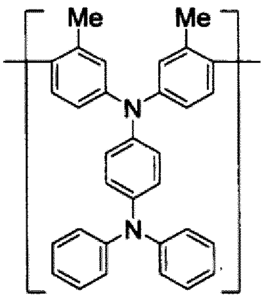

(X1-15)

The structure of "$Ar^{X2}$-$R^{X2}$" and "$Ar^{X3}$-$R^{X4}$" having a cross-linkable group includes, for example, structures represented by the formula (3-1) to formula (3-30).

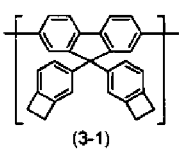

(3-1)

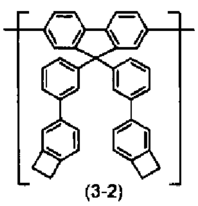

(3-2)

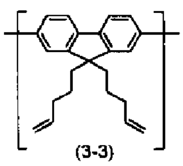

(3-3)

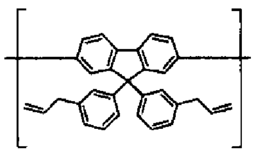

(3-4)

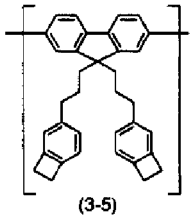

(3-5)

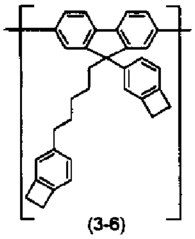

(3-6)

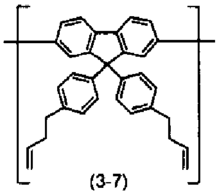

(3-7)

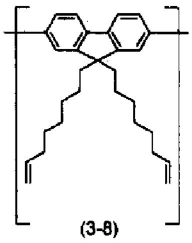

(3-8)

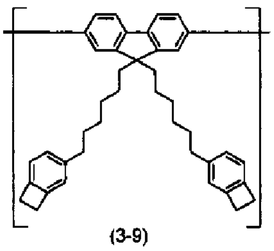

(3-9)

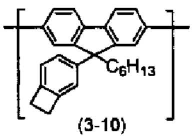

(3-10)

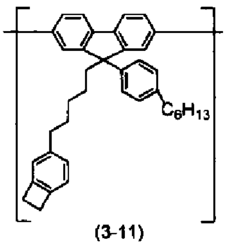

(3-11)

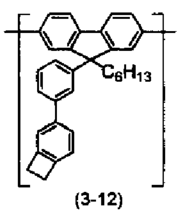

(3-12)

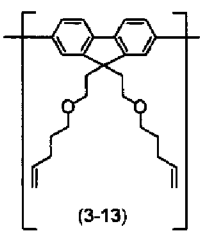

(3-13)

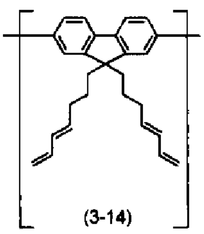

(3-14)

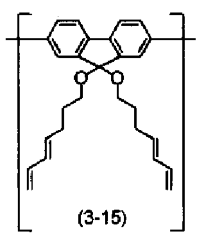

(3-15)

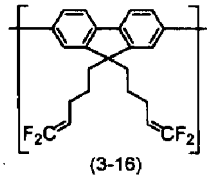
(3-16)
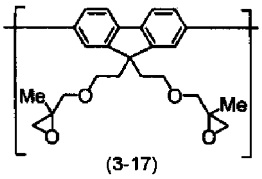
(3-17)
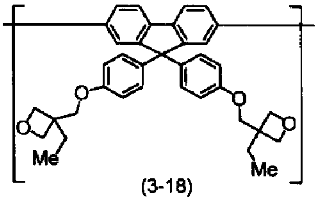
(3-18)
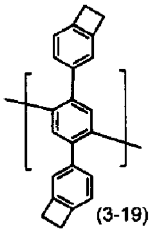
(3-19)
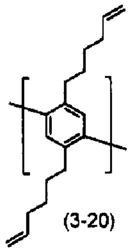
(3-20)

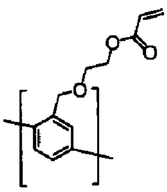
(3-21)
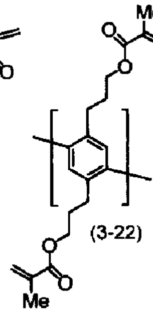
(3-22)
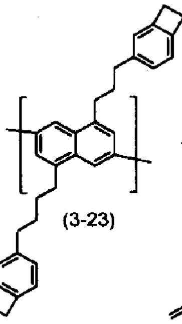
(3-23)
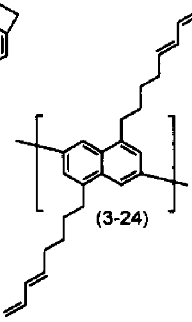
(3-24)
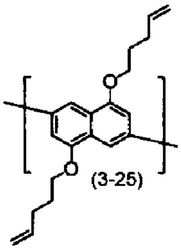
(3-25)
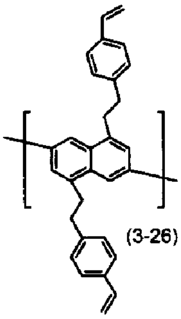
(3-26)

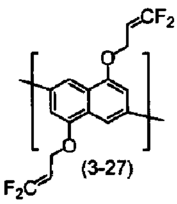
(3-27)
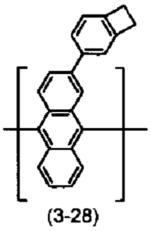
(3-28)
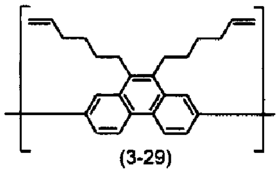
(3-29)
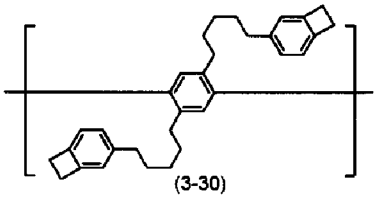
(3-30)

The constitutional unit represented by the formula (X) having a cross-linkable group includes, for example, constitutional units represented by the formula (4-1) to formula (4-9).

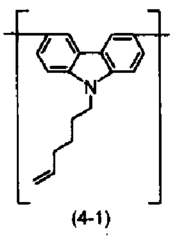
(4-1)
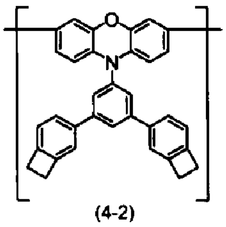
(4-2)
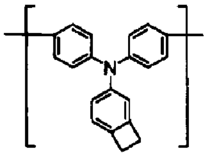
(4-3)
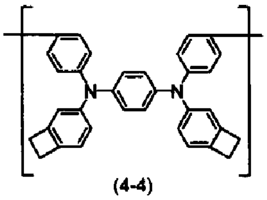
(4-4)
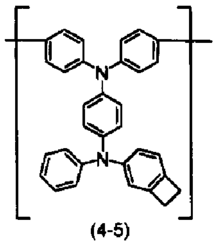
(4-5)

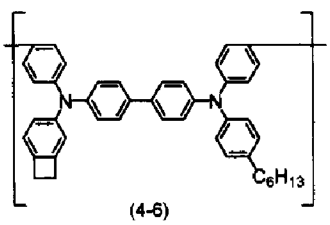
(4-6)
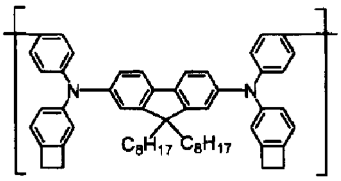
(4-7)
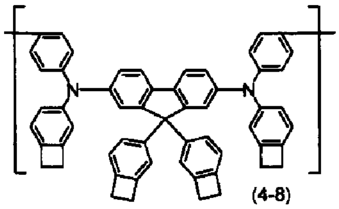
(4-8)

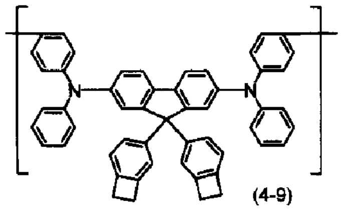

(4-9)

<Constitutional unit represented by the formula (Y)>

The constitutional unit represented by the formula (Y) is as described below.

$$-\left[ Ar^{Y1} \right]- \qquad (Y)$$

[wherein, $Ar^{Y1}$ represents an arylene group, a divalent hetero ring group, or a divalent group in which an arylene group and a divalent hetero ring group are bonded directly, and these groups optionally have a substituent.].

"The arylene group" represented by $Ar^{Y1}$ is preferably a group represented by the formula (A-1) to formula (A-10), formula (A-19) or formula (A-20), more preferably a group represented by the formula (A-1) to formula (A-3), formula (A-6)-formula (A-10), formula (A-19) or formula (A-20), and further preferably a group represented by the formula (A-1), formula (A-2), formula (A-7), formula (A-9) or formula (A-19), since the light emitting device of the present embodiment is more excellent in luminance life.

"The divalent hetero ring group" represented by $Ar^{Y1}$ is preferably a group represented by the formula (AA-1)-formula (AA-4), formula (AA-10)-formula (AA-15), formula (AA-18)-formula (AA-22), formula (AA-33) or formula (AA-34), and more preferably a group represented by the formula (AA-4), formula (AA-10), formula (AA-12) or formula (AA-14), since the light emitting device of the present embodiment is more excellent in luminance life.

The preferable ranges of "the arylene group" and "the divalent hetero ring group" in "the divalent group in which an arylene group and a divalent hetero ring group are bonded directly" represented by $Ar^{Y1}$ are the same as the preferable ranges of "the arylene group" and "the divalent hetero ring group" represented by $Ar^{Y1}$ described above, respectively.

"The divalent group in which an arylene group and a divalent hetero ring group are bonded directly" represented by $Ar^{Y1}$ includes, for example, groups represented by the following formulae, and these optionally have a substituent.

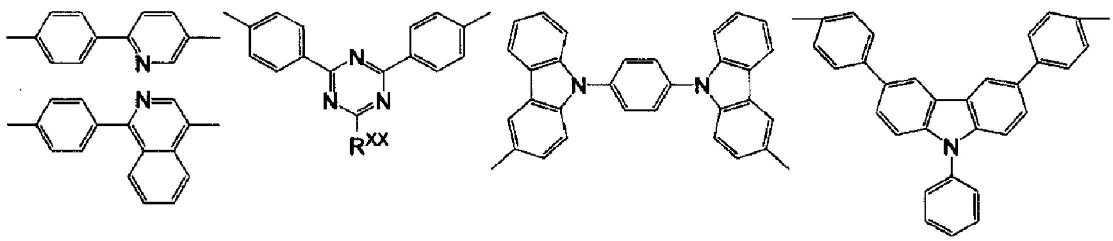

[wherein, $R^{XX}$ represents a hydrogen atom, an alkyl group, a cycloalkyl group, an aryl group or a monovalent hetero ring group, and these groups optionally have a substituent.].

$R^{XX}$ is preferably an alkyl group, a cycloalkyl group or an aryl group, and these groups optionally have a substituent.

The "substituent" which the group represented by $Ar^{Y1}$ optionally has is preferably an alkyl group, a cycloalkyl group, an alkoxy group, a cycloalkoxy group, an aryl group, a monovalent hetero ring group, a substituted amino group, or a group containing a cross-linkable group, more preferably an alkyl group, a cycloalkyl group, an aryl group or a monovalent hetero ring group, and further preferably an alkyl group, a cycloalkyl group or an aryl group, and these groups optionally further have a substituent.

The "substituent" which the substituent which the group represented by $Ar^{Y1}$ optionally has optionally further has is preferably an alkyl group, a cycloalkyl group, an aryl group or a monovalent hetero ring group, and more preferably an alkyl group or a cycloalkyl group, and these groups optionally further have a substituent, but it is preferable that they do not further have a substituent.

The constitutional unit represented by the formula (Y) includes, for example, constitutional units represented by the formula (Y-1) to formula (Y-7) described later, and it is preferably a constitutional unit represented by the formula (Y-1) or formula (Y-2) from the standpoint of the luminance life, preferably a constitutional unit represented by the formula (Y-3) or formula (Y-4) from the standpoint of the electron transportability, and preferably a constitutional unit represented

by the formula (Y-5) to formula (Y-7) from the standpoint of the hole transportability, of the light emitting device of the present embodiment.

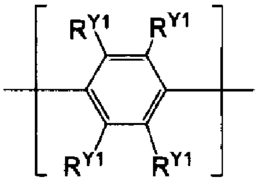

(Y-1)

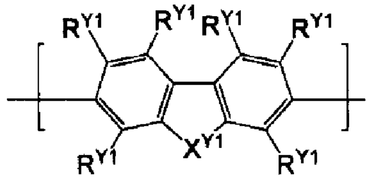

(Y-2)

[wherein, $R^{Y1}$ represents a hydrogen atom, an alkyl group, a cycloalkyl group, an alkoxy group, a cycloalkoxy group, an aryl group or a monovalent hetero ring group, and these groups optionally have a substituent. A plurality of $R^{Y1}$ may be the same or different and may be combined together to form a ring together with carbon atoms to which they are attached.

$X^{Y1}$ represents a group represented by $-C(R^{Y2})_2-$, $- C(R^{Y2})=C(R^{Y2})-$ or $C(R^{Y2})_2-C(R^{Y2})_2-$. $R^{Y2}$ represents a hydrogen atom, an alkyl group, a cycloalkyl group, an alkoxy group, a cycloalkoxy group, an aryl group, a monovalent hetero ring group, or a group containing a cross-linkable group, and these groups optionally have a substituent. A plurality of $R^{Y2}$ may be the same or different and may be combined together to form a ring together with carbon atoms to which they are attached.].

$R^{Y1}$ is preferably a hydrogen atom, an alkyl group, a cycloalkyl group or an aryl group, and these groups optionally have a substituent.

$R^{Y2}$ is preferably an alkyl group, a cycloalkyl group, an aryl group, a monovalent hetero ring group, or a group containing a cross-linkable group, and more preferably an alkyl group, a cycloalkyl group, an aryl group, or a group containing a cross-linkable group, and these groups optionally have a substituent.

The examples and the preferable range of the substituent which $R^{Y1}$ and $R^{Y2}$ optionally have are the same as the examples and the preferable range of the substituent which the substituent which the group represented by $Ar^{Y1}$ optionally has optionally further has.

In $X^{Y1}$, the combination of two groups $R^{Y2}$ in the group represented by $-C(R^{Y2})_2-$ is preferably a combination in which both are alkyl groups or cycloalkyl groups, both are aryl groups, both are monovalent hetero ring groups, or one is an alkyl group or a cycloalkyl group and the other is an aryl group or a monovalent hetero ring group, and more preferably a combination in which one is an alkyl group or a cycloalkyl group and the other is an aryl group, and these groups optionally have a substituent. Two groups $R^{Y2}$ may be combined together to form a ring together with atoms to which they are attached, and when $R^{Y2}$ forms a ring, the group represented by $-C(R^{Y2})_2-$ is preferably a group represented by the formula (Y-A1) to formula (Y-A5), and more preferably a group represented by the formula (Y-A4), and these groups optionally have a substituent.

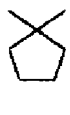

(Y-A1)

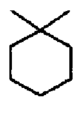

(Y-A2)

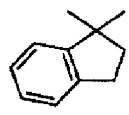

(Y-A3)

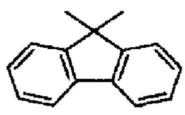

(Y-A4)

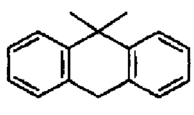

(Y-A5)

In $X^{Y1}$, the combination of two groups $R^{Y2}$ in the group represented by $-C(R^{Y2})=C(R^{Y2})-$ is preferably a combination in which both are alkyl groups or cycloalkyl groups, or one is an alkyl group or a cycloalkyl group and the other is an aryl group, and these groups optionally have a substituent.

In $X^{Y1}$, four groups $R^{Y2}$ in the group represented by $- C(R^{Y2})_2-C(R^{Y2})_2-$ are preferably alkyl groups or cycloalkyl groups optionally having a substituent. A plurality of $R^{Y2}$ may be combined together to form a ring together with atoms to which they are attached, and when $R^{Y2}$ forms a ring, the group represented by $-C(R^{Y2})_2-C(R^{Y2})_2-$ is preferably a group represented by the formula (Y-B1) to formula (Y-B5), and more preferably a group represented by the formula (Y-B3), and these groups optionally have a substituent.

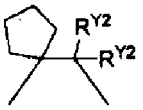
(Y-B1)

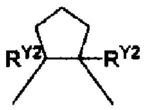
(Y-B2)

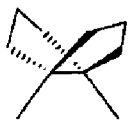
(Y-B3)

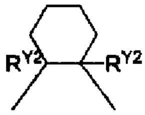
(Y-B4)

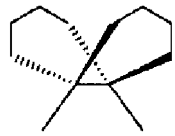
(Y-B5)

[wherein, $R^{Y2}$ represents the same meaning as described above.].

The constitutional unit represented by the formula (Y-1) is preferably a constitutional unit represented by the formula (Y-1'). The constitutional unit represented by the formula (Y-2) is preferably a constitutional unit represented by the formula (Y-2').

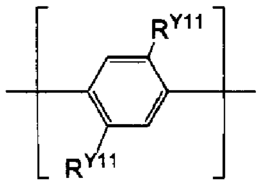
(Y-1')

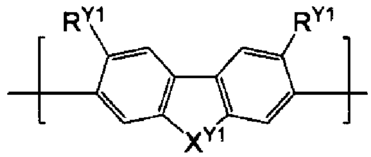
(Y-2')

[wherein, $R^{Y1}$ and $X^{Y1}$ represent the same meaning as described above. $R^{Y11}$ represents an alkyl group, a cycloalkyl group, an alkoxy group, a cycloalkoxy group, an aryl group or a monovalent hetero ring group, and these groups optionally have a substituent. A plurality of $R^{Y11}$ may be the same or different.].

$R^{Y11}$ is preferably an alkyl group, a cycloalkyl group or an aryl group, and more preferably an alkyl group or a cycloalkyl group, and these groups optionally have a substituent.

The examples and the preferable range of the substituent which $R^{Y11}$ optionally has are the same as the examples and the preferable range of the substituent which the substituent which the group represented by $Ar^{Y1}$ optionally has optionally further has.

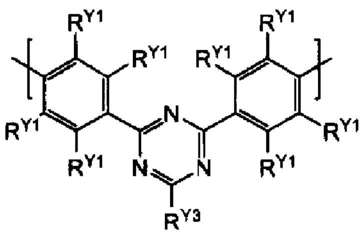
(Y-3)

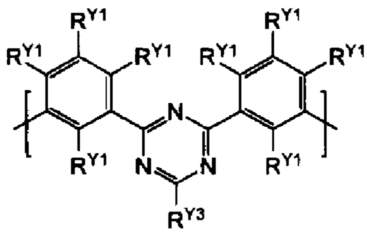
(Y-4)

[wherein, $R^{Y1}$ represents the same meaning as described above. $R^{Y3}$ represents a hydrogen atom, an alkyl group, a cycloalkyl group, an alkoxy group, a cycloalkoxy group, an aryl group or a monovalent hetero ring group, and these groups optionally have a substituent.].

$R^{Y3}$ is preferably an alkyl group, a cycloalkyl group, an alkoxy group, a cycloalkoxy group, an aryl group or a monovalent hetero ring group, and more preferably an aryl group, and these groups optionally have a substituent.

The examples and the preferable range of the substituent which $R^{Y3}$ optionally has are the same as the examples and the preferable range of the substituent which the substituent which the group represented by $Ar^{Y1}$ optionally has optionally further has.

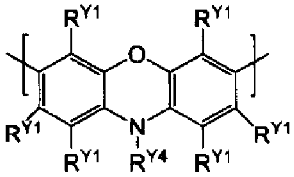
(Y-5)

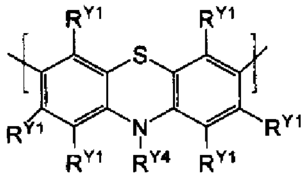
(Y-6)

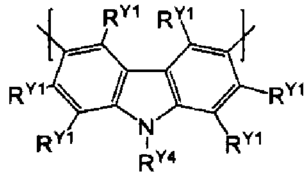
(Y-7)

[wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent hetero ring group, and these groups optionally have a substituent.].

$R^{Y4}$ is preferably an alkyl group, a cycloalkyl group, an alkoxy group, a cycloalkoxy group, an aryl group or a monovalent hetero ring group, and more preferably an aryl group, and these groups optionally have a substituent.

The examples and the preferable range of the substituent which $R^{Y4}$ optionally has are the same as the examples and the preferable range of the substituent which the substituent which the group represented by $Ar^{Y1}$ optionally has optionally further has.

The constitutional unit represented by the formula (Y) includes, for example, constitutional units represented by the formula (Y-11) to formula (Y-55).

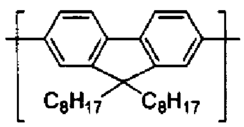
(Y-11)

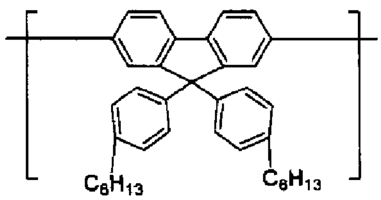
(Y-12)

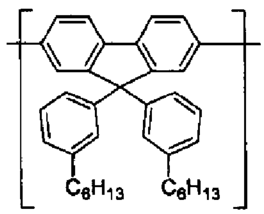
(Y-13)

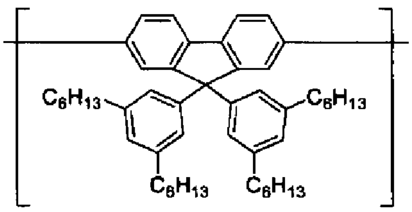
(Y-14)

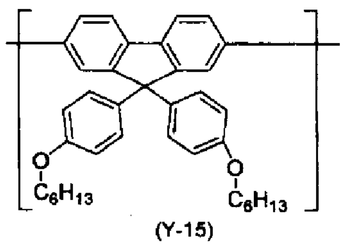
(Y-15)

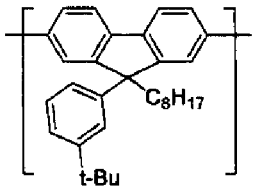
(Y-16)

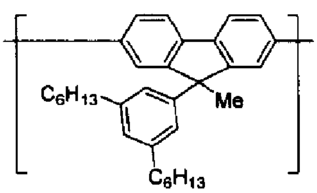
(Y-17)

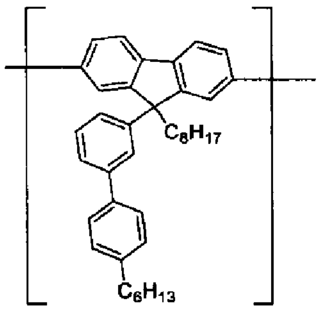
(Y-18)

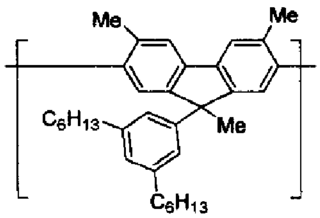
(Y-19)

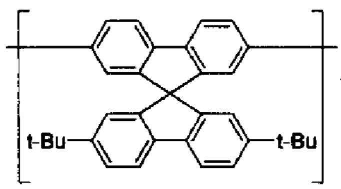
(Y-20)

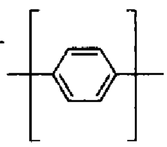
(Y-21)

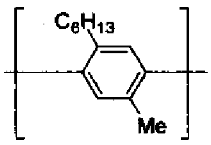
(Y-22)

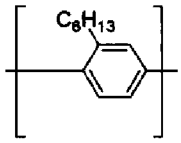
(Y-23)

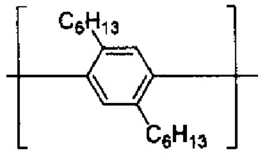
(Y-24)

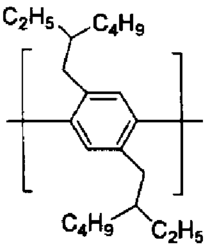
(Y-25)

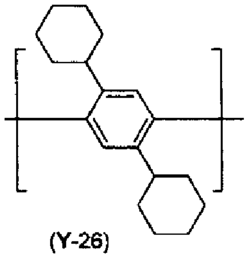
(Y-26)

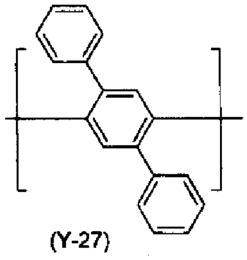
(Y-27)

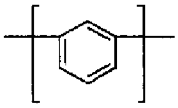
(Y-28)

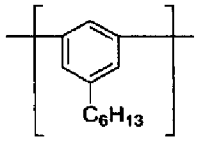
(Y-29)

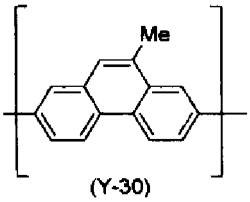
(Y-30)

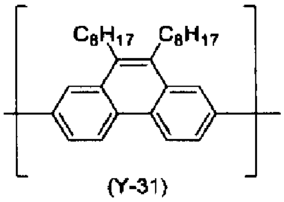
(Y-31)

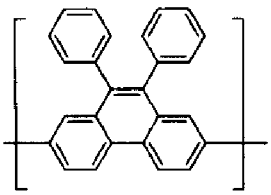
(Y-32)

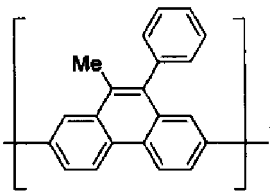
(Y-33)

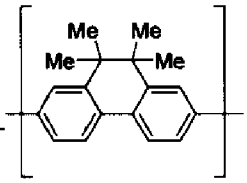
(Y-34)

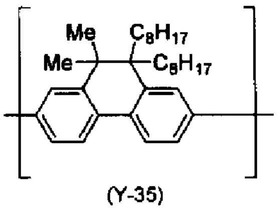
(Y-35)

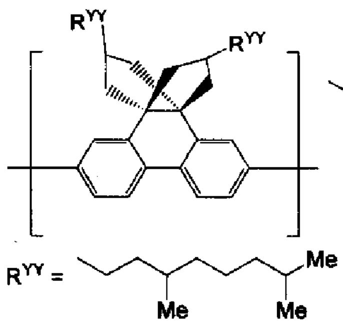
(Y-36)

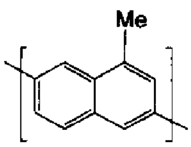
(Y-37)

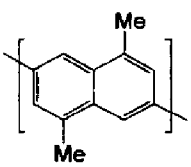
(Y-38)

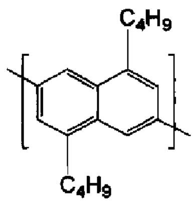
(Y-39)

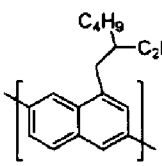
(Y-40)

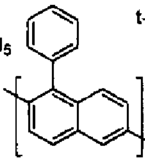
(Y-41)

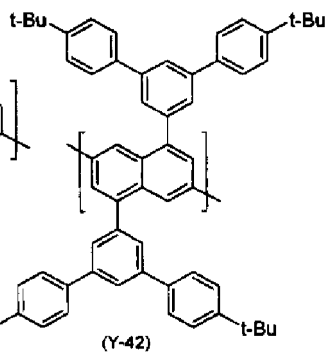
(Y-42)

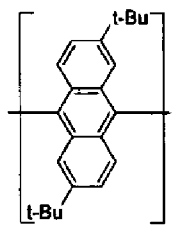
(Y-43)

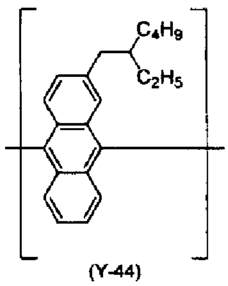
(Y-44)

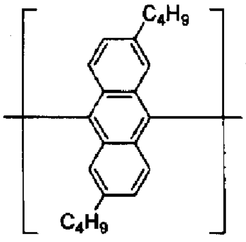
(Y-45)

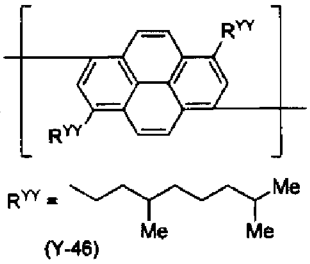
(Y-46)

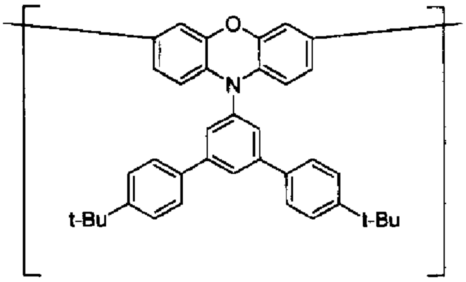
(Y-47)

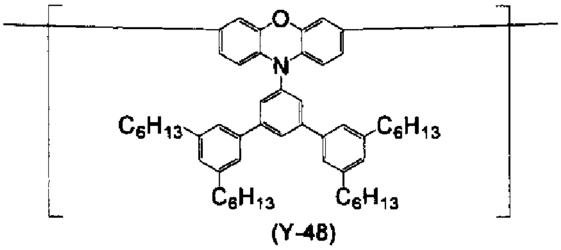
(Y-48)

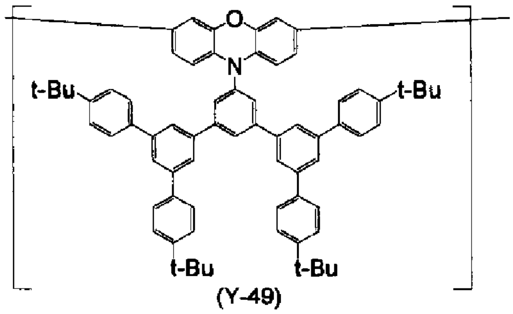
(Y-49)

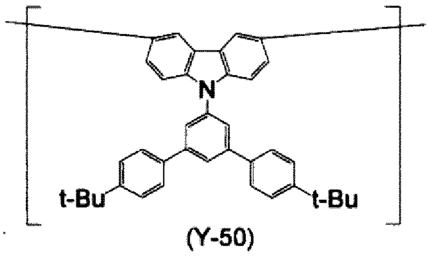
(Y-50)

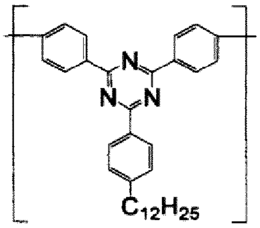
(Y-51)

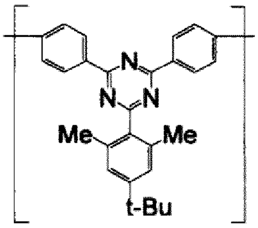
(Y-52)

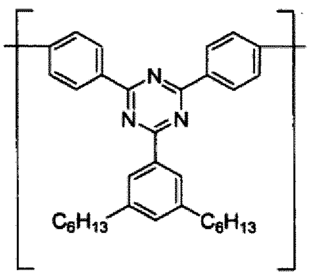
(Y-53)

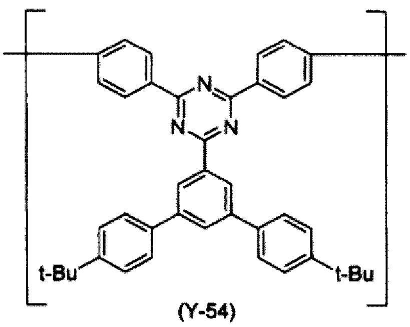
(Y-54)

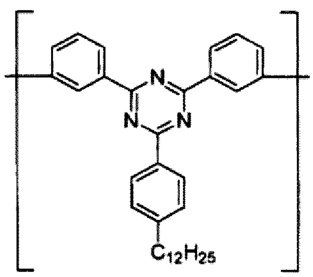
(Y-55)

<Other constitutional unit>

The above-described polymer compound may further contain other constitutional units. The other constitutional units are constitutional units other than a constitutional unit represented by the formula (X) and a constitutional unit represented by the formula (Y), and can be arbitrarily selected as long as the effect of the present invention is exhibited.

<Production method of polymer compound>

The above-described polymer compound can be produced using known polymerization methods described in Chemical Reviews (Chem. Rev.), vol. 109, pp. 897-1091 (2009), and the like. For example, methods for polymerizing by a coupling reaction using a transition metal catalyst such as the Suzuki reaction, the Yamamoto reaction, the Buchwald

reaction, the Stille reaction, the Negishi reaction, the Kumada reaction, and the like are mentioned.

The monomers used in polymerization are compounds in which two connecting bonds have a reactive group suitable for the coupling reaction such as a constitutional unit represented by the formula (X), a constitutional unit represented by the formula (Y), and other constitutional units, described above.

In the above-described polymerization method, the method of charging monomers includes a method of charging the entire amount of monomers into the reaction system at once, a method in which a part of monomers is charged and reacted, and then the remaining monomers are charged in a batch, continuously or dividedly, a method of charging monomers continuously or dividedly, and the like.

The transition metal catalyst includes a palladium catalyst, a nickel catalyst, and the like.

For the post treatment of the polymerization reaction, known methods can be used. For example, a method of removing water-soluble impurities by liquid separation, a method in which the reaction liquid after the polymerization reaction is added to a lower alcohol such as methanol and the like, the deposited precipitate is filtrated, then, dried, and other methods, can be used singly or in combination of two or more. When the purity of the polymer compound containing a constitutional unit having a cross-linkable group is low, it can be purified by usual methods such as, for example, recrystallization, reprecipitation, continuous extraction with Soxhlet extractor, column chromatography, and the like.

(2) Cyclic low molecular compound

The cyclic low molecular compound contained in the composition of the present invention is a compound in which the above-described constitutional units represented by the formula (X) are bonded directly or bonded via other atom, group or constitutional unit, to form a ring. The cyclic low molecular compound is usually a compound which is byproduced when polymerizing monomers in the production method of the polymer compound.

The cyclic low molecular compound contains one or more constitutional units represented by the formula (X). When two or more constitutional units represented by the formula (X) are contained, the constitutional units may be the same or different.

It is preferable that the cyclic low molecular compound further contains one or more constitutional units represented by the formula (Y). When two or more constitutional units represented by the formula (Y) are contained, the constitutional units may be the same or different.

The molecular weight of the cyclic low molecular compound is usually 200 to 10000, preferably 1000 to 10000.

The cyclic low molecular compound is preferably a compound having a constitutional unit represented by the formula (X) and a constitutional unit represented by the formula (Y), and more preferably a compound consisting of a constitutional unit represented by the formula (X) and a constitutional unit represented by the formula (Y).

The cyclic low molecular compound includes, for example, cyclic compounds represented by the formula (Z) described below.

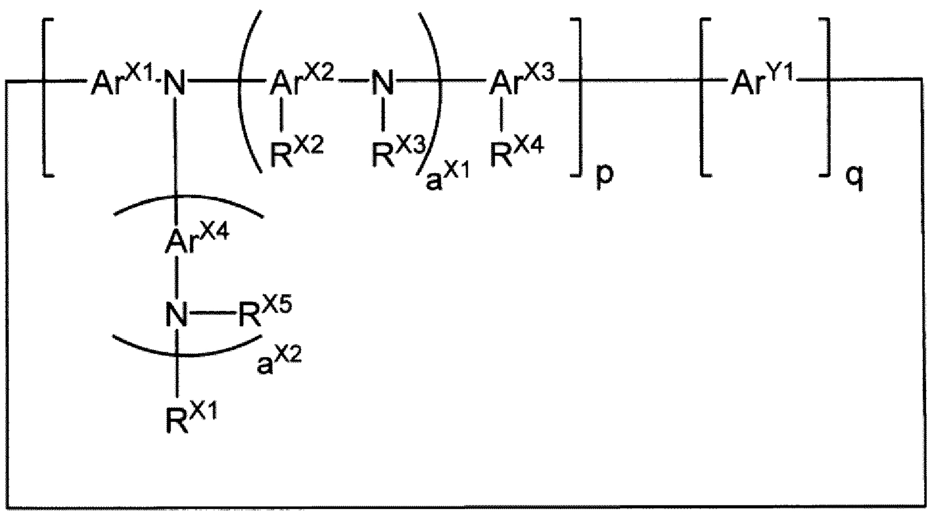

(Z)

[wherein, p represents an integer of 1 to 8, q represents an integer of 0 to 8, and $3 \leq p+q \leq 16$. Other marks are as defined above. The order of bonding of the constitutional unit represented by the formula (X) and the constitutional unit represented by the formula (Y) is not restricted. When a plurality of constitutional units represented by the formula (X) are present, the constitutional units may be the same or different. When a plurality of constitutional units represented by the formula (Y) are present, the constitutional units may be the same or different.].

The cyclic compounds represented by the formula (Z) in which p is an integer of 2 to 8 and q is an integer of 2 to 8 are preferable, and the cyclic compounds in which p is an integer of 3 to 6 and q is an integer of 3 to 6 are more preferable.

Analysis of the structure of these cyclic low molecular compounds can be carried out using, for example, mass spectrometry using matrix-assisted laser desorption ionization (MALDI-TOFMS).

The cyclic low molecular compound specifically includes, for example, compounds represented by the following formulae.

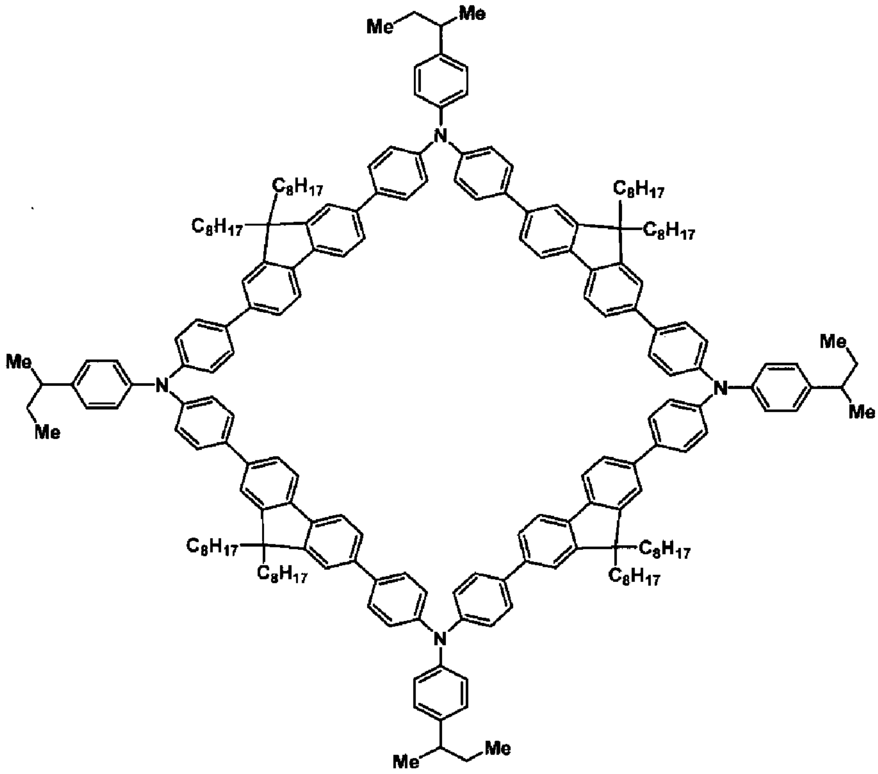

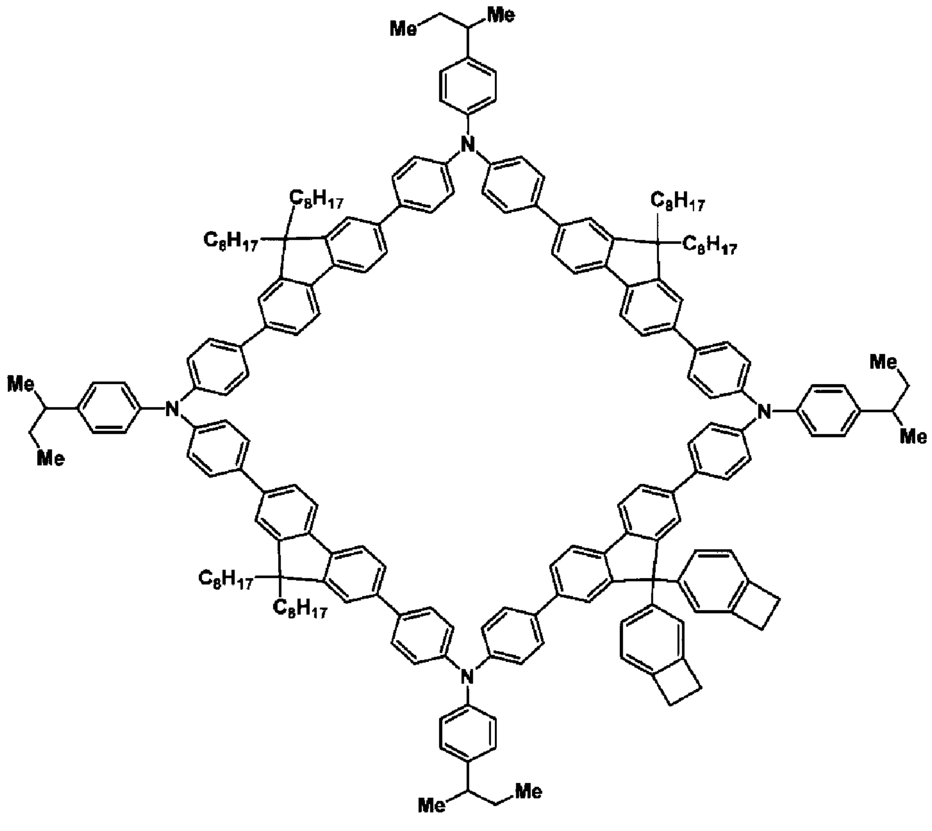

(3) Other material which can be contained in composition

The composition of the present invention may contain other materials. The other materials include, for example, a hole transporting material, a hole injection material, an electron transporting material, an electron injection material, a light emitting material, and an antioxidant. The composition of the present invention may further contain at least one

material selected from the group consisting of these materials.

[Hole transporting material]

The hole transporting material is classified into a low molecular compound and a polymer compound, and is preferably a polymer compound having a cross-linkable group.
The polymer compound includes, for example, polyvinylcarbazole and derivatives thereof; and polyarylene having an aromatic amine structure in the side chain or main chain and derivatives thereof. The polymer compound may be a compound to which an electron accepting site is bonded such as fullerene, tetrafluorotetracyanoquinodimethane, tetracyanoethylene and trinitrofluorenone, and the like.
In the composition of the present invention, the blending amount of the hole transporting material is usually 1 to 400 parts by mass when the sum of the above-described cyclic low molecular compound and the above-described polymer compound is taken as 100 parts by mass. The hole transporting material may be used singly or in combination of two or more.

[Electron transporting material]

The electron transporting material is classified into a low molecular compound and a polymer compound. The electron transporting material may have a cross-linkable group.
The low molecular compound includes, for example, metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.
The polymer compound includes, for example, polyphenylene, polyfluorene, and derivatives thereof. The polymer compound may be doped with a metal.
In the composition of the present invention, the blending amount of the electron transporting material is usually 1 to 400 parts by mass when the sum of the abovedescribed cyclic low molecular compound and the above-described polymer compound is taken as 100 parts by mass. The electron transporting material may be used singly or in combination of two or more.

[Hole injection material and electron injection material]

The hole injection material and the electron injection material are each classified into a low molecular compound and a polymer compound. The hole injection material and the electron injection material may have a cross-linkable group.
The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride, and the like.
The polymer compound includes electrically conductive polymers such as, for example, polyaniline, polythiophene, polypyrrole, polyphenylenevinylene, polythienylenevinylene, polyquinoline and polyquinoxaline, and derivatives thereof; polymers having an aromatic amine structure in the main chain or side chain, and the like.
In the composition of the present invention, the blending amounts of the hole injection material and the electron injection material are each usually 1 to 400 parts by mass when the sum of the above-described cyclic low molecular compound and the above-described polymer compound is taken as 100 parts by mass. The hole injection material and the electron injection material each may be used singly or in combination of two or more.

[Ion doping]

When the hole injection material or the electron injection material contains a conductive polymer, the electric conductivity of the conductive polymer is preferably $1\times10^{-5}$ S/cm to $1\times10^{3}$ S/cm. In order to regulate the electric conductivity of the conductive polymer within such a range, the conductive polymer can be doped with an appropriate amount of ions.

[Light emitting material]

The light emitting material is classified into a low molecular compound and a polymer compound. The light emitting material may have a cross-linkable group.
The low molecular compound includes, for example, naphthalene and derivatives thereof, anthracene and derivatives thereof, perylene and derivatives thereof, and triplet light emitting complexes having iridium, platinum or europium as the central metal.

The polymer compound includes polymer compounds containing, for example, an arylene group such as a phenylene group, a naphthalenediyl group, a fluorenediyl group, a phenanthrenediyl group, a dihydrophenanthrenediyl group, an anthracenediyl group, a pyrenediyl group and the like; an aromatic amine residue such as a group obtained by removing two hydrogen atoms from an aromatic amine, and the like; and a divalent hetero ring group such as a carbazolediyl group, a phenoxazinediyl group, a phenothiazinediyl group, and the like.

The triplet light emitting complex includes, for example, metal complexes shown below.

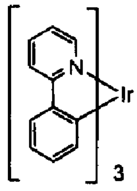
Ir(ppy)3

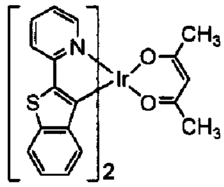
Btp2Ir(acac)

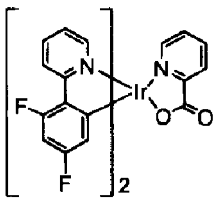
FIrpic

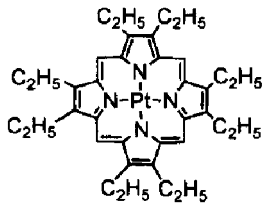
PtOEP

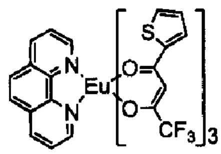
Eu(TTA)3phen

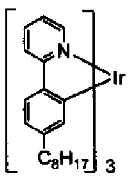
COM-1

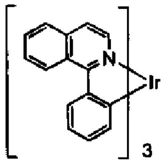
COM-2

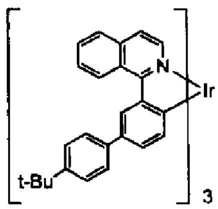
COM-3

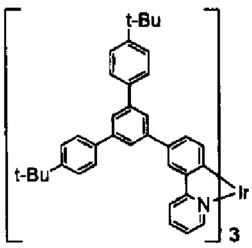
COM-4

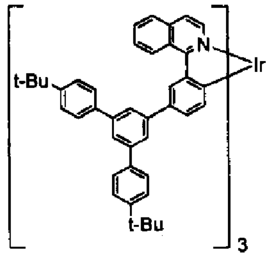
COM-5

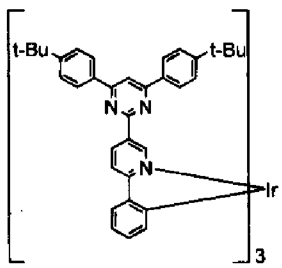
COM-6

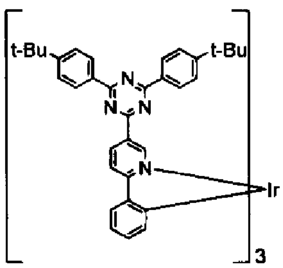
COM-7

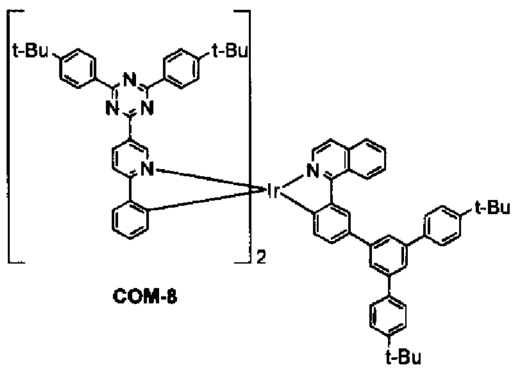
COM-8

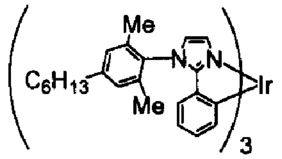
COM-14

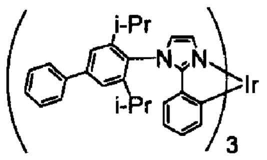
COM-15

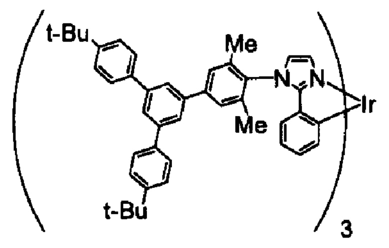
COM-16

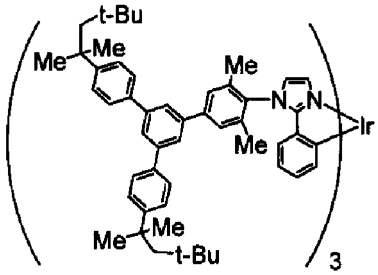
COM-17

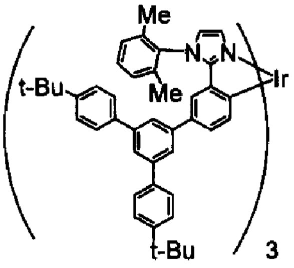
COM-18

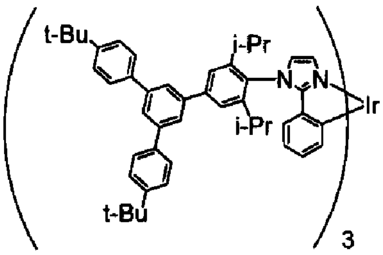
COM-19

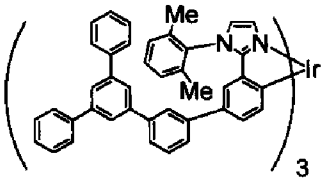
COM-20

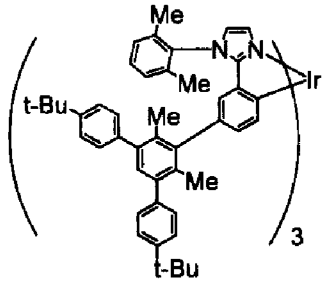
COM-21

In the composition of the present invention, the content of the light emitting material is usually 0.1 to 400 parts by mass with respect to 100 parts by mass of the sum of the above-described cyclic low molecular compound and the above-described polymer compound. The light emitting material may be used singly or in combination of two or more.

[Antioxidant]

The antioxidant may be a compound which is soluble in the same solvent as for a cross-linkable material having a cross-linkable group and which does not inhibit light emission and charge transportation, and includes, for example, phenol type antioxidants and phosphorus-based antioxidants.

In the composition of the present invention, the blending amount of the antioxidant is usually 0.001 to 10 parts by mass with respect to 100 parts by mass of the sum of the above-described cyclic low molecular compound and the above-described polymer compound. The antioxidant may be used singly or in combination of two or more.

3. Analysis of cyclic low molecular compound in composition

The method for analyzing the amount of a cyclic low molecular compound contained in the composition of the present invention includes, for example, high performance liquid chromatography and mass spectrometry. The method for analyzing by high performance liquid chromatography includes, for example, a method in which the composition of the present invention is dissolved in a solvent, and this solution is measured by high performance liquid chromatography. The solvent for dissolving the composition includes, for example, tetrahydrofuran, toluene, and the like.

The method for quantifying a cyclic low molecular compound contained in the composition of the present invention will be illustrated in detail. First, the composition of the present invention is dissolved in a solvent. Regarding the proportion of the composition and the solvent in the solution, the amount of the solvent is usually 2000 parts by mass to 100 parts by mass with respect to 1 part by mass of the composition. The resultant solution of the composition is measured by high performance liquid chromatography. The column used for measurement includes a column in which a silica gel carrier is modified with an octadecyl group (ODS column). Since a polymer compound is contained in the composition, the pore diameter of the column is desirably 80 Å to 300 Å. The cyclic low molecular compound contained in the composition of the present invention is calculated by way of the area percentage in liquid chromatography.

The method of investigating the measurement condition of liquid chromatography will be illustrated in detail. First, a good solvent in the composition of the present invention is used as a mobile phase and measurement is conducted with only the sample dissolution solvent, and the retention time of the solvent-derived peak is recorded. Next, the composition of the present invention is measured under the same condition, and the area values of all the peaks are added up. Next, 1% by volume of a poor solvent in the composition of the present invention is added to the mobile phase and the measurement is carried out, and the area values of the resultant peaks are added up. This operation is repeated, and when the area value of the peak obtained in liquid chromatography is reduced by 10% or more with respect to the area value when the mobile phase is composed only of a good solvent, the mobile phase composition is recorded. The condition in which the poor solvent composition of the mobile phase is reduced by 1% by volume with respect to this

mobile phase composition is defined as the measurement condition used for quantification of a cyclic low molecular compound. At this condition, the peak close to the peak of the sample dissolution solvent corresponds to the peak of a cyclic low molecular compound. The good solvent for the composition includes, for example, toluene, tetrahydrofuran, and the like, and the poor solvent for the composition includes, for example, acetonitrile, methanol, and the like.

For analysis of the structure of the compound contained in each peak, each peak is collected and the solution is condensed, and the analysis can be carried out using mass spectrometry using matrix-assisted laser desorption ionization (MALDI-TOFMS).

Based on the result of liquid chromatography measured as described above, the area percentage of a cyclic low molecular compound can be calculated by the following formula.

Area percentage of cyclic low molecular compound = area value of cyclic low molecular compound/(area value of cyclic low molecular compound + area value of polymer compound)×100

Note that since a plurality of cyclic low molecular compounds are contained in the composition in some cases, several peaks of the cyclic low molecular compounds may be detected. In this case, the sum of areas of all the peaks of a plurality of cyclic low molecular compounds corresponds to the peak area of the cyclic low molecular compound.

## 4. Film for light emitting device

By using the composition of the present invention, a film for light emitting device containing the composition of the present invention and/or a cured product thereof can be formed. The film for light emitting device can be used, for example, as an organic layer of a light emitting device. The thickness of the film for light emitting device is usually 1 nm to 10 μm.

The film for light emitting device can be fabricated by a wet method such as, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method, and the like using a composition containing a polymer compound, a cyclic low molecular compound and a solvent (hereinafter, referred to as "ink"). The viscosity of the ink may be adjusted depending on the type of the wet method, and it is preferably 1 to 20 mPa•s at 25°C.

The solvent contained in the ink is preferably a solvent capable of dissolving or uniformly dispersing a solid content in the ink. In the ink, the use amount of the solvent is usually 10 to 1000 parts by mass with respect to 1 part by mass of the sum of the above-described cyclic low molecular compound and the above-described polymer compound. The solvent includes, specifically, aromatic hydrocarbon solvents such as toluene, xylene, and the like; and ether solvents such as tetrahydrofuran, dioxane, and the like.

In fabrication of the film for light emitting device, when a constitutional unit represented by the formula (X) and/or a constitutional unit represented by the formula (Y) contained in a polymer compound has a cross-linkable group, the heating temperature for crosslinking the polymer compound is usually 50°C to 300°C, and more preferably 190°C to 220°C. The heating time is usually 1 minute to 1000 minutes, and preferably 40 minutes to 80 minutes. Further, crosslinking may be performed by irradiation with ultraviolet ray, near ultraviolet ray, visible light or the like.

## 5. Light emitting device

The light emitting device of the present embodiment is a light emitting device having an anode, a cathode, and an organic layer disposed between the above-described anode and the above-described cathode and containing the above-described composition. The organic layer includes, for example, a light emitting layer, a hole transporting layer, a hole injection layer, an electron transporting layer, and an electron injection layer. At least one of these layers contains the composition of the present invention.

The organic layer containing the composition of the present invention is usually at least one layer selected from the group consisting of a light emitting layer, a hole transporting layer, a hole injection layer, an electron transporting layer and an electron injection layer, and preferably a hole transporting layer. The materials contained in these layers include the light emitting material, the hole transporting material, the electron transporting material, the hole injection material, the electron injection material and the like described above, in addition to the composition of the present

invention.

These organic layers can be formed by dissolving the composition of the present invention and a light emitting material, a hole transporting material, a hole injection material, an electron transporting material or an electron injection material in the solvent described above to prepare an ink, and using the same method as for fabrication of the film for light emitting device described above.

The light emitting device has a light emitting layer between an anode and a cathode. The light emitting device of the present embodiment preferably has at least one of a hole injection layer and a hole transporting layer between an anode and a light emitting device from the standpoint of hole injectability and hole transportability, and preferably has at least one of an electron injection layer and an electron transporting layer between a cathode and a light emitting layer from the standpoint of electron injectability and electron transportability.

The method for forming each layer such as a light emitting layer, a hole transporting layer, an electron transporting layer, a hole injection layer, an electron injection layer and the like in the light emitting device of the present embodiment usually include, for example, a vacuum vapor deposition method from a powder and a method by film formation from a solution or melted state when using a low molecular compound, and a method by film formation from a solution or melted state when using a polymer compound. The order, number and thickness of layers to be laminated are adjusted in consideration of light emission efficiency and luminance life.

These laminated organic layers (particularly, a hole transporting layer, an electron transporting layer and a light emitting layer) are preferably formed by a wet film formation method. The wet film formation method is a method in which solutions containing organic materials are applied sequentially to form a plurality of organic layers. However, in applying another solution on the formed organic layer, the organic layer may be dissolved in the solution, and the organic material may elute or mix across the layer, thus, exerting a reverse influence on the properties of a light emitting device. To avoid this, it is preferable that the organic material has a cross-linkable group. That is, each layer is applied and formed using an organic material having a cross-linkable group, then, the cross-linkable group is crosslinked to insolubilize the layer, accordingly, its curability is improved, and an organic layer excellent in light emitting device properties can be formed. Particularly, it is preferable that the polymer compound contained in the composition of the present invention has one or more cross-linkable groups.

Further, the composition of the present invention contains a predetermined proportion of the cyclic low molecular compound, together with the polymer compound. Hence, the organic layer (film) formed by a wet film formation method using a solution containing the composition becomes a layer in which its curability is improved and solvent resistance is excellent (see, film remaining ratio in examples and comparative examples in Table 1). The reason for this is not necessarily clear, but it is thought to be due to the following reason. In general, in order to improve the film remaining ratio of an organic layer, it is necessary to reduce the motility of the molecules in the composition. While the linear polymer component, which occupies the majority of the composition, can perform translational motion, the cyclic low molecular compound tends to be entangled with the linear component and has low motility. It is supposed that the inclusion of such a cyclic low molecular compound having low motility in a small amount in the composition causes a decrease in the motility of the entire composition, resulting in an increase in the film remaining ratio, namely, an improvement in the film curability.

The substrate in the light emitting device may be a substrate on which electrodes can be formed and which does not chemically change when forming an organic layer and is, for example, a substrate made of a material such as glass, plastic, silicon and the like. In the case of an opaque substrate, it is preferable that the electrode farthest from the substrate is transparent or semitransparent.

The material of an anode includes, for example, electrically conductive metal oxides, and semitransparent metals, preferably, indium oxide, zinc oxide and tin oxide; electrically conductive compounds such as indium•tin•oxide (ITO), indium•zinc•oxide and the like; argentine-palladium-copper composite (APC); NESA, gold, platinum, silver, and copper.

The material of a cathode includes, for example, metals such as lithium, sodium, potassium, rubidium, cesium, beryllium, magnesium, calcium, strontium, barium, aluminum, zinc, indium and the like; alloys composed of two or more of them; alloys composed of one or more of them and one or more of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode each may take a laminated structure composed of two or more layers.

The light emitting device of the present embodiment can be used, for example, for displays of computer, television, portable terminal and the like, and for illumination.

[EXAMPLES]

The present invention will be illustrated further in detail by examples below, but the present invention is not

limited to these examples.

(Measurement of weight-average molecular weight)

In examples, the polystyrene-equivalent weight-average molecular weight (Mw) of a polymer compound was measured by gel permeation chromatography (GPC) using tetrahydrofuran as the mobile phase.

(Condition for gel permeation chromatography (GPC))

A polymer compound to be measured was dissolved at a concentration of about 0.05% by mass in tetrahydrofuran, 10 μL of the solution was injected into a GPC apparatus (manufactured by Tosoh Corp., trade name: HLC-8320 GPC). The mobile phase was flowed at a flow rate of 1.0 mL/min. As the column, PLgel MIXED-B (manufactured by Polymer Laboratories Inc.) was used. As the detector, UV-VIS detector (manufactured by Tosoh Corp., trade name: UV-8320 GPC) was used.

<Synthesis Example 1>

A nitrogen gas atmosphere was prepared in a reaction vessel, then, a compound (M1) (19.0569 g (21.50 mmol)), a compound (M2) (17.413 g (18.94 mmol)), a compound (M3) (1.788 g (3.34 mmol)), dichlorobis[tris(2-methoxyphenyl)phosphine]palladium (5.89 mg (0.0068 mmol)), and toluene (569 g) were mixed and heated at 80°C. To the resultant mixture was added a 20% by mass tetraethylammonium hydroxide aqueous solution (77.1 g) and the mixture was stirred for 3 hours, and further, the compound (M1) (0.233 g (0.26 mmol)) was added and the mixture was stirred for 1 hour. Thereafter, to this was added phenylboronic acid (272 mg), and the mixture was further stirred for 15 hours.

Thereafter, it was cooled to room temperature (25°C), and the reaction liquid was diluted with toluene (2344 g) and washed with ion-exchanged water (150 g). The resultant toluene solution was purified by passing through a column in which alumina and silica gel were mixed. The resultant toluene solution was washed with 10% by mass hydrochloric acid (150 g), 3% by mass ammonia water (150 g) and ion-exchanged water (150 g) in this order each twice, and purified by passing through a column in which alumina and silica gel were mixed.

The resultant toluene solution was added dropwise to 4.5 times the amount of methanol, the mixture was stirred for 1 hour, then, the resultant solid was isolated by filtration and dried, to obtain a mixture A (27.8 g) of a polymer compound (P1) and a cyclic low molecular compound 1.

The polystyrene-equivalent weight-average molecular weight of the mixture A was $1.07 \times 10^5$. According to the result of liquid chromatography described in the section of (Quantification of cyclic low molecular compound) described later (FIG. 1), the amount of the cyclic low molecular compound 1 contained in the mixture A (area percentage) was 8.0%.

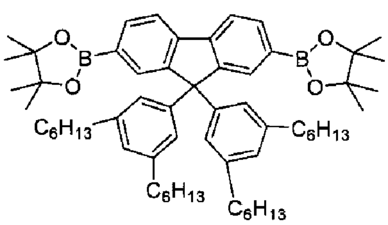

**(M1)**

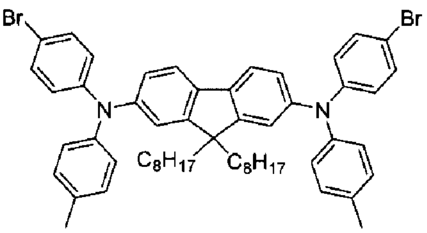

**(M2)**

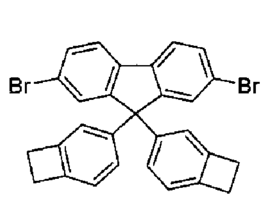

**(M3)**

Further, the cyclic low molecular compound 1 was subjected to analysis of the structure according to the section of (Quantification of cyclic low molecular compound) described later, and resultantly, it was confirmed to be a compound represented by the following formula. These compounds correspond to the results in FIG. 3. In the following formulae, (M1') represents a divalent group obtained by removing two reactive groups (-B (pin)) from the raw material compound (M1), (M2') represents a divalent group obtained by removing two bromine atoms from the raw material compound (M2), and (M3') represents a divalent group obtained by removing two bromine atoms from the raw material compound (M3).

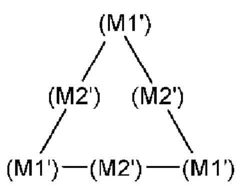

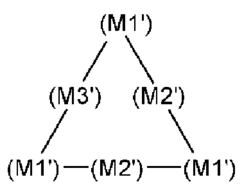

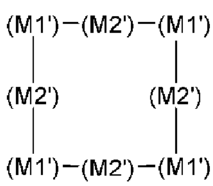

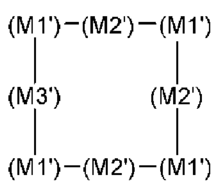

<Synthesis Example 2>

The mixture A (8.0 g) obtained in Synthesis Example 1 was dissolved in toluene, to prepare a 1.0% by mass solution (800 g). This solution was added dropwise to 3200 g of ethyl acetate, and the mixture was further stirred for 2 hours and half, then, allowed to stand still, to precipitate a polymer compound. Decantation was performed to remove the supernatant, then, 500 g of toluene was added to the resultant precipitate, to re-dissolve it. The resultant toluene solution was added dropwise to 2600 g of a methanol solution, and the mixture was further stirred for 40 minutes, then, the resultant solid was isolated by filtration and dried, to obtain a polymer compound (P2) (5.6 g) .

The polystyrene-equivalent weight-average molecular weight of the polymer compound (P2) was $1.34\times10^5$. According to the result of liquid chromatography described in the section of (Quantification of cyclic low molecular compound) described later (FIG. 2), no cyclic low molecular compound was detected in the reaction system.

(Quantification of cyclic low molecular compound)

Quantification of the cyclic low molecular compound 1 contained in the mixture A obtained in Synthesis Example 1 and the polymer compound (P2) obtained in Synthesis Example 2 was performed according to the following method.

(Step 1)

Five milligrams (5 mg) of the sample (mixture A or polymer compound (P2)) was weighed, and dissolved in 5 mL of tetrahydrofuran. It was allowed to stand still at room temperature (25°C) until the solid content disappeared, to dissolve the sample.

(Step 2)

The liquid chromatography measurement of the sample solution was carried out under the following conditions.

- Liquid chromatography apparatus: Shimadzu Corp., LC-20A series
- Mobile phase: tetrahydrofuran/acetonitrile = 76/24 (% by volume)
- Column: manufactured by GL Science, Inertsil ODS WP300, 4.6 mm×250 mm
- Measurement temperature: 35°C
- Detector: Shimadzu Corp., SPD-20A, 365 nm
- Flow rate: 0.5 mL/min

The peaks of the main components of the mixture A appeared around 4.0 minutes, and small peaks appeared also around 6.0 minutes which was the time where the solvent was eluted. Each peak was collected, the solution was condensed, then, mass spectrometry using matrix-assisted laser desorption ionization (MALDI-TOFMS) was performed to analyze the structure, as a result, it was confirmed that the peaks around 4.0 minutes were derived from the polymer compound (P1) and the peaks around 6.0 minutes were derived from a plurality of cyclic low molecular compounds 1. Specifically, the components around 6.0 minutes in the chart of liquid chromatography of the mixture A in FIG. 1 were collected, and analyzed by MALDI-TOFMS. The results are shown in FIG. 3.

When the polymer compound (P2) was subjected to the structural analysis in the same manner, the peaks around 4.0 minutes were derived from the polymer compound (P2), and peaks derived from the cyclic low molecular compound were not observed (FIG. 2).

The area percentage of the cyclic low molecular compound was calculated by the following formula based on the results of liquid chromatography. The area of the cyclic low molecular compound and the polymer compound was determined using LC analysis soft (LabSolutions, manufactured by Shimadzu Corp.) in FIG. 1. For the treatment of a part where peaks overlap, the area value and the area percentage were determined by vertically dividing at the minimum points between the peaks.

Area percentage of cyclic low molecular compound = area value of cyclic low molecular compound/(area value of cyclic low molecular compound + area value of polymer compound)×100

<Examples 1 to 3, Comparative Examples 1 to 3> Evaluation of film remaining ratio

The film remaining ratio was evaluated according to the method described in [0458] to [0463] of International Publication WO2016/047536. The mixture A obtained in Synthesis Example 1 and the polymer compound (P2) obtained in Synthesis Example 2 were mixed at a prescribed proportion (% by mass), and the film remaining ratio was evaluated. The results are shown in Table 1 and FIG. 4.

[Table 1]

| | Mixing ratio (% by mass) | | Cyclic low molecular compound area percentage (%) | Film remaining ratio (%) |
|---|---|---|---|---|
| | Mixture A | Polymer compound (P2) | | |
| Comparative Example 1 | 0.0 | 100.0 | 0.0 | 71.8 |
| Example 1 | 2.5 | 97.5 | 0.2 | 73.2 |
| Example 2 | 6.3 | 93.7 | 0.5 | 75.0 |
| Example 3 | 12.5 | 87.5 | 1.0 | 73.4 |
| Comparative Example 2 | 25.0 | 75.0 | 2.0 | 71.0 |
| Comparative Example 3 | 50.0 | 50.0 | 4.0 | 66.3 |

Based on the results in Table 1 and FIG. 4, when a prescribed proportion of the cyclic low molecular compound is used, the film remaining ratio is improved, that is, the film curability is recognized to improve.

Industrial Applicability

By using the composition of the present invention, it is possible to form an organic layer excellent in curability in a light emitting device.

**Claims**

1. A composition comprising cyclic low molecular compounds having a constitutional unit represented by the formula (X), and a polymer compound having the same constitutional unit represented by the formula (X) as in said cyclic low molecular compound, wherein the total value of area percentages determined by liquid chromatography of said cyclic low molecular compounds is 0.1 or more and 1.5 or less when the total value of area percentages determined by liquid chromatography of said cyclic low molecular compounds and said polymer compound is taken as 100:

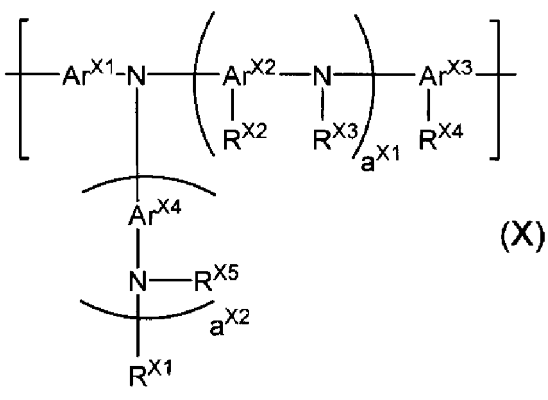

(X)

wherein,

$a^{x1}$ and $a^{X2}$ each independently represent an integer of 0 or more,
$Ar^{x1}$ and $Ar^{X3}$ each independently represent an arylene group or a divalent hetero ring group, and these groups optionally have a substituent,
$Ar^{X2}$ and $Ar^{X4}$ each independently represent an arylene group, a divalent hetero ring group, or a divalent group in which an arylene group and a divalent hetero ring group are bonded directly, and these groups optionally have a substituent, when a plurality of $Ar^{X2}$ and $Ar^{X4}$ are present, they may be the same or different at each

occurrence,
$R^{X1}$ to $R^{X5}$ each independently represent a hydrogen atom, an alkyl group, a cycloalkyl group, an aryl group, a monovalent hetero ring group, or a group containing a cross-linkable group, and these groups optionally have a substituent, when a plurality of $R^{X2}$, $R^{X3}$ and $R^{X5}$ are present, they may be the same or different at each occurrence.

2. The composition accoding to claim 1, wherein the molecular weight of said cyclic low molecular compound is 1000 to 10000.

3. The composition according to claim 1 or 2, comprising a cyclic low molecular compound having a constitutional unit represented by said formula (X) and a constitutional unit represented by the formula (Y), and a polymer compound having the same constitutional unit represented by the formula (X) and the same constitutional unit represented by the formula (Y) as in said cyclic low molecular compound:

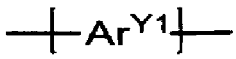 (Y)

wherein, $Ar^{Y1}$ represents an arylene group, a divalent hetero ring group, or a divalent group in which an arylene group and a divalent hetero ring group are bonded directly, and these groups optionally have a substituent.

4. The composition according to any one of claims 1 to 3, wherein said cyclic low molecular compound is a cyclic compound represented by the formula (Z):

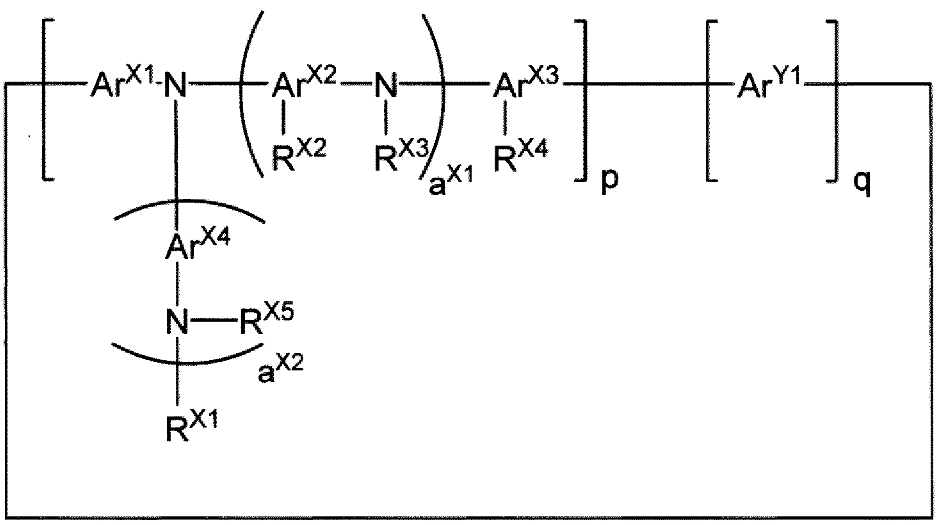 (Z)

wherein, p represents an integer of 1 to 8, q represents an integer of 0 to 8, and $3 \leq p+q \leq 16$, other marks are as defined above, the order of bonding of the constitutional unit represented by the formula (X) and the constitutional unit represented by the formula (Y) is not restricted, when a plurality of constitutional units represented by the formula (X) are present, the constitutional units may be the same or different, when a plurality of constitutional units represented by the formula (Y) are present, the constitutional units may be the same or different.

5. The composition according to any one of claims 1 to 4, further comprising at least one selected from the group consisting of a hole transporting material, a hole injection material, an electron transporting material, an electron injection material, a light emitting material and an antioxidant.

6. A film for light emitting device, comprising the composition as described in any one of claims 1 to 5 and/or a cured product thereof.

7. A light emitting device having an anode, a cathode and an organic layer, wherein said organic layer is disposed between said anode and said cathode, and said organic layer is the film for light emitting device as described in claim 6.

[Fig. 1]

Mixture A (polymer compound P1 + cyclic low molecular compound 1) Mw: $1.07\times10^5$

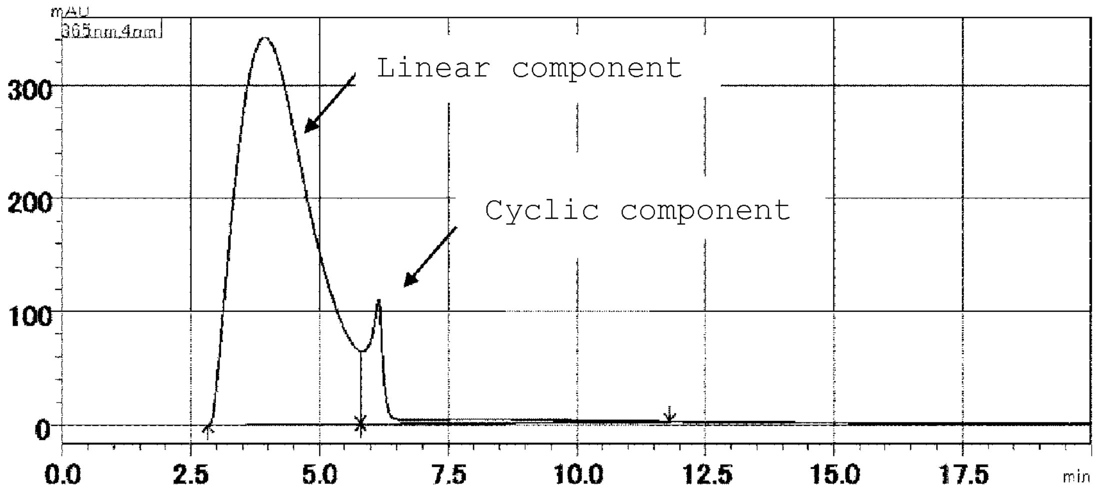


[Fig. 2]

Polymer compound P2 (after removal of low molecular weight component) Mw: $1.34\times10^5$

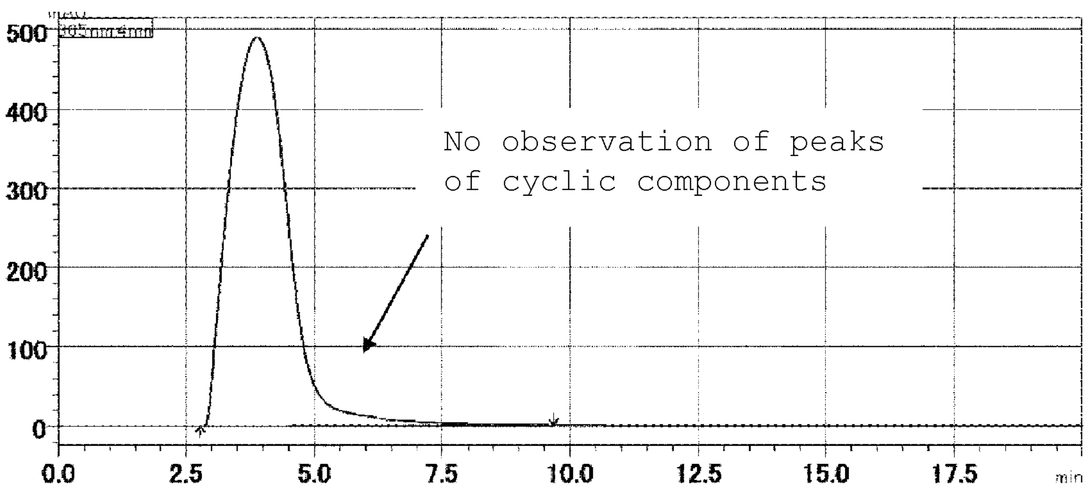


[Fig. 3]

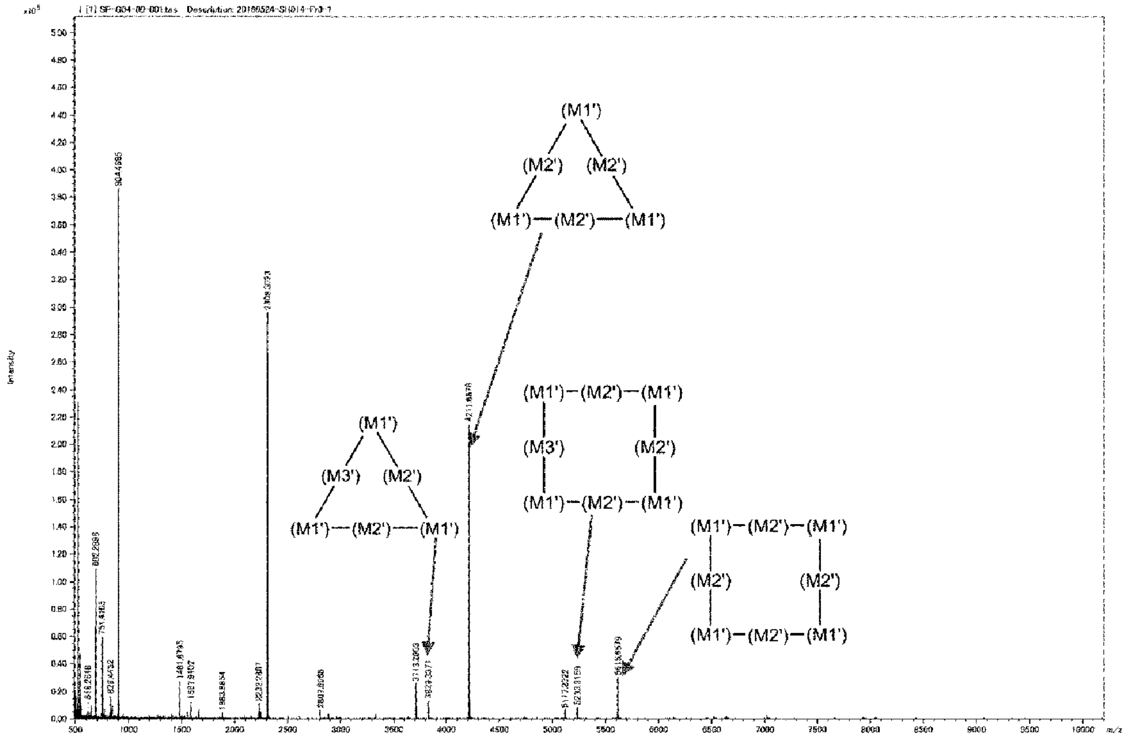
(M1')
(M2') (M2')
(M1')—(M2')—(M1')
(M1')
(M3') (M2')
(M1')—(M2')—(M1')
(M1')—(M2')—(M1')
(M3') (M2')
(M1')—(M2')—(M1')
(M1')—(M2')—(M1')
(M2') (M2')
(M1')—(M2')—(M1')

[Fig. 4]

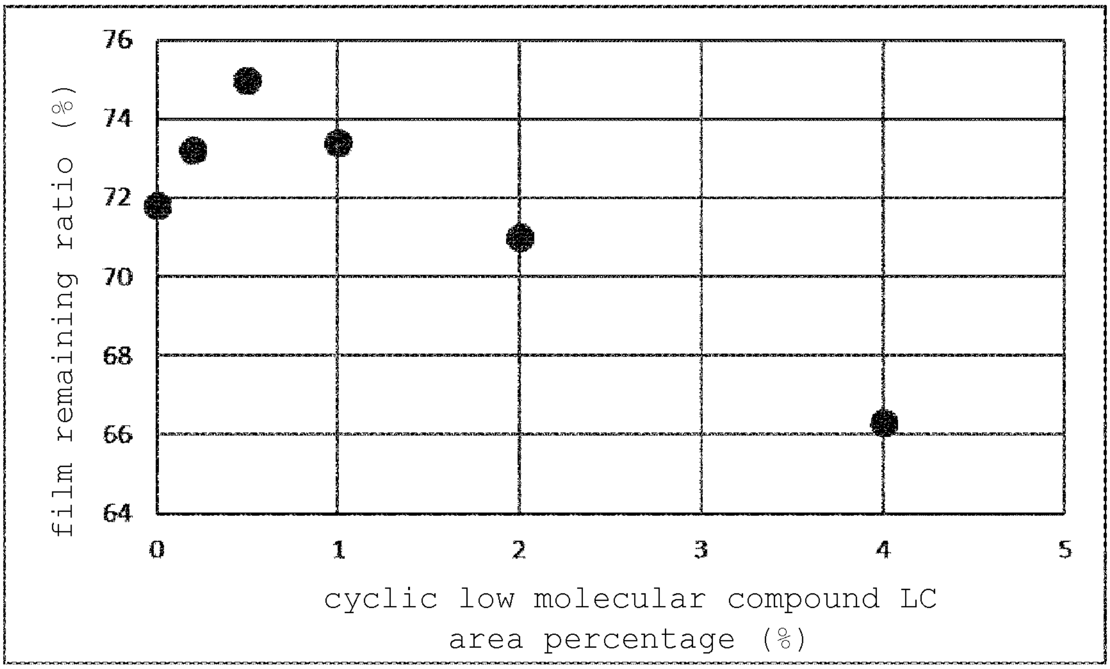
film remaining ratio (%)
76
74
72
70
68
66
64
0
1
2
3
4
5
cyclic low molecular compound LC
area percentage (%)

**INTERNATIONAL SEARCH REPORT**

International application No. PCT/JP2020/034231

A. CLASSIFICATION OF SUBJECT MATTER
Int.Cl. C08G61/12(2006.01)i, C08K5/00(2006.01)i, C08K5/18(2006.01)i, C08L65/00(2006.01)i, H01L51/50(2006.01)i
FI: C08L65/00, C08K5/18, C08K5/00, C08G61/12, H05B33/22D, H05B33/22B, H05B33/14B
According to International Patent Classification (IPC) or to both national classification and IPC

B. FIELDS SEARCHED
Minimum documentation searched (classification system followed by classification symbols)
Int.Cl. C08G61/12, C08K5/00, C08K5/18, C08L65/00, H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2017/047644 A1 (SUMITOMO CHEMICAL CO., LTD.) 23 March 2017 (2017-03-23), entire text | 1-7 |
| A | JP 2011-102355 A (TOKYO UNIVERSITY OF AGRICULTURE AND TECHNOLOGY) 26 May 2011 (2011-05-26), entire text | 1-7 |
| A | WO 2018/168667 A1 (HODOGAYA CHEMICAL CO., LTD.) 20 September 2018 (2018-09-20), entire text | 1-7 |
| A | WO 2016/031639 A1 (SUMITOMO CHEMICAL CO., LTD.) 03 March 2016 (2016-03-03), entire text | 1-7 |
| A | JP 2014-001349 A (SUMITOMO CHEMICAL CO., LTD.) 09 January 2014 (2014-01-09), entire text | 1-7 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 November 2020 | 24 November 2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/034231

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-155985 A (MITSUBISHI CHEMICAL CORPORATION) 15 July 2010 (2010-07-15), entire text | 1-7 |
| A | WO 2013/114976 A1 (SUMITOMO CHEMICAL CO., LTD.) 08 August 2013 (2013-08-08), entire text | 1-7 |
| A | WO 2013/146806 A1 (SUMITOMO CHEMICAL CO., LTD.) 03 October 2013 (2013-10-03), entire text | 1-7 |
| P, A | WO 2020/009069 A1 (HODOGAYA CHEMICAL CO., LTD.) 09 January 2020 (2020-01-09), entire text | 1-7 |
| P, A | WO 2020/066509 A1 (SUMITOMO CHEMICAL CO., LTD.) 02 April 2020 (2020-04-02), entire text | 1-7 |
| P, A | WO 2020/066510 A1 (SUMITOMO CHEMICAL CO., LTD.) 02 April 2020 (2020-04-02), entire text | 1-7 |
| P, A | JP 2020-107869 A (SAMSUNG ELECTRONICS CO., LTD.) 09 July 2020 (2020-07-09), entire text | 1-7 |

Form PCT/ISA/210 (second sheet) (January 2015)

**INTERNATIONAL SEARCH REPORT**
Information on patent family members

International application No.
PCT/JP2020/034231

| | | |
|---|---|---|
| WO 2017/047644 A1 | 23 March 2017 | US 2018/0230264 A1<br>entire text<br>EP 3351576 A1<br>CN 108026254 A |
| JP 2011-102355 A | 26 May 2011 | (Family: none) |
| WO 2018/168667 A1 | 20 September 2018 | US 2019/0378989 A1<br>entire text<br>EP 3597689 A1<br>CN 110382590 A<br>KR 10-2019-0126059 A<br>TW 201839029 A |
| WO 2016/031639 A1 | 03 March 2016 | US 2017/0253795 A1<br>entire text<br>EP 3187522 A1<br>KR 10-2017-0046715 A<br>CN 106795277 A<br>TW 201630964 A |
| JP 2014-001349 A | 09 January 2014 | (Family: none) |
| JP 2010-155985 A | 15 July 2010 | JP 2014-1399 A |
| WO 2013/114976 A1 | 08 August 2013 | US 2014/0367617 A1<br>entire text<br>TW 201348292 A |
| WO 2013/146806 A1 | 03 October 2013 | US 2015/0115204 A1<br>entire text<br>EP 2832761 A1<br>CN 104321362 A<br>KR 10-2014-0148424 A<br>TW 201345947 A |
| WO 2020/009069 A1 | 09 January 2020 | (Family: none) |
| WO 2020/066509 A1 | 02 April 2020 | JP 2020-56004 A |
| WO 2020/066510 A1 | 02 April 2020 | JP 2020-56005 A |
| JP 2020-107869 A | 09 July 2020 | (Family: none) |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005209626 A
- WO 2016047536 A


### Non-patent literature cited in the description


- *Chemical Reviews (Chem. Rev.),* 2009, vol. 109, 897-1091